(19)

Europäisches
Patentamt

European
Patent Office

Office européen
des brevets

(11) **EP 2 631 799 A1**

(12) **EUROPEAN PATENT APPLICATION**
published in accordance with Art. 153(4) EPC

| | |
|---|---|
| (43) Date of publication:<br>**28.08.2013 Bulletin 2013/35** | (51) Int Cl.:<br>***G06F 9/50*** (2006.01)  ***F24F 11/02*** (2006.01)<br>***G06F 9/46*** (2006.01) |
| (21) Application number: **10858669.4** | (86) International application number:<br>**PCT/JP2010/068764** |
| (22) Date of filing: **22.10.2010** | (87) International publication number:<br>**WO 2012/053115 (26.04.2012 Gazette 2012/17)** |

| | |
|---|---|
| (84) Designated Contracting States:<br>**AL AT BE BG CH CY CZ DE DK EE ES FI FR GB<br>GR HR HU IE IS IT LI LT LU LV MC MK MT NL NO<br>PL PT RO RS SE SI SK SM TR** | (72) Inventor: **MIYAUCHI, Keiji**<br>**Kawasaki-shi**<br>**Kanagawa 211-8588 (JP)** |
| (71) Applicant: **Fujitsu Limited**<br>**Kawasaki-shi, Kanagawa 211-8588 (JP)** | (74) Representative: **HOFFMANN EITLE**<br>**Patent- und Rechtsanwälte**<br>**Arabellastrasse 4**<br>**81925 München (DE)** |

(54) **DATA CENTER, INFORMATION PROCESSING SYSTEM, INFORMATION PROCESSING DEVICE, METHOD FOR CONTROLLING INFORMATION PROCESSING DEVICE, AND CONTROL PROGRAM**

(57)     A data center includes an air-conditioner and an information processing system that includes a plurality of servers that is cooled with air flowing from an outlet port from the air-conditioner. Each of the plurality of servers executes a program and acquires first air volume information measured by an air volume meter that measures an air volume from an outlet port corresponding to the subject device. Moreover, each of the plurality of servers acquires a second air volume measured by an air volume meter that measures an air volume from an outlet port corresponding to each of the other servers information processing devices. Further, each of the plurality of servers specifies other servers that are cooled with a larger air volume than the air volume that cools the subject device based on the first air volume information and the second air volume information. After that, each of the plurality of servers migrates the executed program to the specified other server.

FIG.4

**Description**

Field

The present invention relates to a data center, an information processing system, an information processing device, a method for controlling the information processing device, and a control program.

Background

Conventionally, in a data center that includes racks on which information technology (IT) instruments are mounted and servers in which electronic circuits and the like are included, the IT instruments and the servers are cooled using an air-conditioner that takes in warm air and supplies cool air.

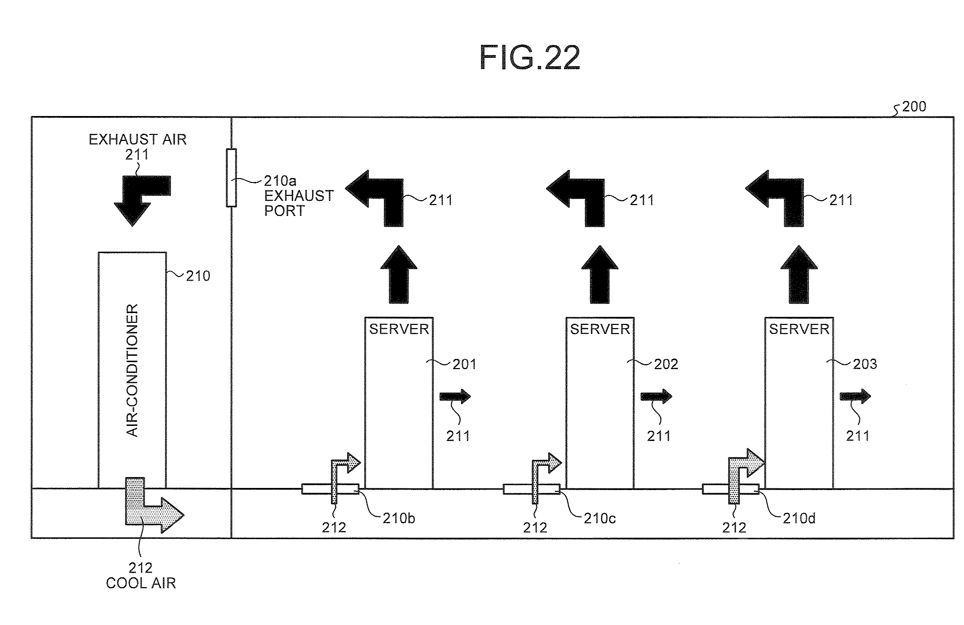

For example, FIG. 22 is a diagram illustrating an arrangement example of servers in a computer center, a data center, or the like. An air-conditioner 210 in FIG. 22 takes in warm air 211 exhausted from servers 201 to 203 to a data center 200 through an exhaust port 210a and supplies low-temperature cool air 212 to the space under the floor. The servers 201 to 203 are installed so as to correspond to the outlet ports 201b to 210d installed on the floor, respectively, and the cool air 212 supplied to the space under the floor is taken in to cool internal electronic circuits and the like. The servers 201 to 203 exhaust the air 211 heated to cool the electronic circuits and the like into the data center 200. In this manner, in the data center 200, the cool air 212 and the exhaust air 211 are circulated by the air-conditioner 210, whereby servers are cooled.

In such a data center, a technique of monitoring airflow in the data center and controlling cool air supplied by an air-conditioning facility based on the monitoring results is known. Moreover, a technique of predicting load and power consumption of servers installed in a data center and controlling the volume of cool air supplied by an air-conditioner based on the predicting results is known.

Citation List

Patent Literature

Patent Literature 1: Japanese Laid-open Patent Publication No. 2006-208000
Patent Literature 2: Japanese Laid-open Patent Publication No. 2009-293851

Non-Patent Literature

Non-Patent Literature 1: "Green Data Center (Latest Technology on Air-Conditioning)", available online at http://www.impressrd.jp/idc/2008spring/sp1/part1souron.html, searched on July 26, 2009

Summary

Technical Problem

However, the conventional techniques have a problem in that the cooling efficiency of the servers installed in the data center is not satisfactory regardless of the volume of cool air supplied to the data center.

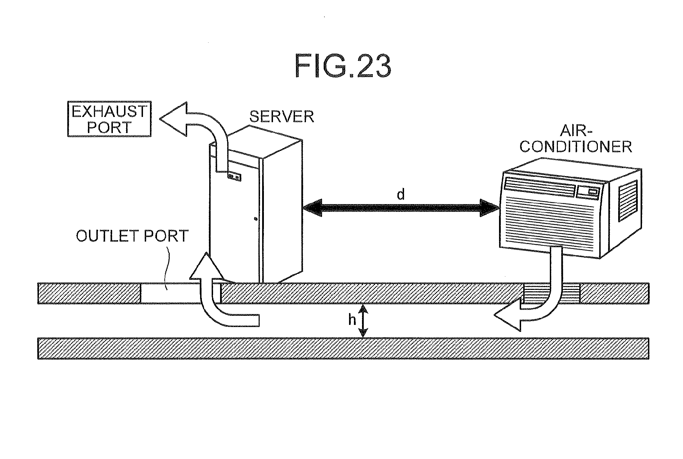

For example, in a data center, it is known that due to the relation between the height (h) of the space under the floor and the distance (d) between an air-conditioner and a server illustrated in FIG. 23, a pressure difference in the cool air supplied from the air-conditioner occurs, and the volume of air flowing from an outlet port changes. That is, the volume of air flowing from an outlet port closer to the air-conditioner is not always larger than the volume of air flowing from an outlet port farther from the air-conditioner. For example, when the height of the space under the floor is larger than a predetermined value, the volume of air flowing from the outlet port farther from the air-conditioner will be larger than that of the outlet port closer to the air-conditioner. FIG. 23 is a diagram illustrating the height of the space under the floor and the distance to the air-conditioner.

Moreover, it is difficult to change the installed location of a server which has been installed in a data center and begun to operate. For example, since a server that has been operated once is already operating a system, if the server is moved, the system will be stopped, which may cause a trouble in system operations. Further, when the server is moved, the outlet ports are also moved, which may also incur time and cost in designing and reconstructing the space under the floor.

Thus, when servers and outlet ports are installed in a data center, by taking the height of the space under the floor and the distance from the air-conditioner into consideration, an outlet port capable of flowing a large volume of air is installed so as to correspond to a server emitting a large amount of heat, and an outlet port capable of flowing a small volume of air is installed so as to correspond to a server emitting a small amount of heat. The amount of heat emitted by the server may change after the server starts operating depending on various conditions such as an increase in the use rate and the operating time of a central processing unit (CPU) and the number of users using a server and an operation state of a virtual machine operating in a server.

For example, it is assumed that a plurality of servers is installed in a data center, and a processing load of a server which emitted a small amount of heat when the server was installed in the data center has increased so that the amount of heat emitted by the server has increased. Since this server is installed so as to correspond to an outlet port capable of flowing a small volume of air, it is not possible to sufficiently cool the server. On the other hand, as described above, it is difficult to change the installed location of the server in which the amount of heat emission has increased. Under this condition, if the volume of cool air supplied from an air-conditioner is increased using the conventional technique, although the server in which the amount of heat emission has increased takes in an increased volume of cool air, the other servers which was already cooled before the volume of air has increased also take in an increased volume of cool air.

In short, the conventional technique simply increases the volume of cool air supplied from the air-conditioner. Hence, a part of the cool air is wasted, while the power consumption and the costs increase due to the increased air flow; and therefore the server installed in the data center does not always achieve a high cooling efficiency.

The present invention has been made in view of the above problems, and an object of the present invention is to provide a data center, an information processing system, an information processing device, a method for controlling the information processing device, and a control program capable of improving the cooling efficiency of the servers installed in the data center.

Solution to Problem

To solve the problems as described above and to achieve an object, one embodiment of a data center, information processing system, information processing device, method of controlling an information processing device, and a control program disclosed herein is a data center including an air-conditioner, and an information processing system including a plurality of information processing devices that is cooled with air flowing from an outlet port from the air-conditioner. Each of the plurality of information processing devices includes an arithmetic processing unit that executes a program, and a first air volume information acquiring unit that acquires first air volume information measured by an air volume meter that measures an air volume from an outlet port corresponding to the subject device. Further, each of the plurality of information processing devices includes a second air volume information acquiring unit that acquires second air volume information measured by an air volume meter that measures an air volume from an outlet port corresponding to each of other information processing devices. Further, each of the plurality of information processing devices includes a determining unit that specifies the other information processing devices that are cooled with a larger air volume than the air volume that cools the subject device based on the first air volume information and the second air volume information. Further, each of the plurality of information processing devices includes a migration control unit that migrates a program executed by the arithmetic processing unit to the other information processing device that is specified by the determining unit.

Advantageous Effects of Invention

The disclosed data center, information processing system, information processing device, method for controlling the information processing device, and control program provide advantages that the cooling efficiency of the servers installed in the data center can be improved. Brief Description of Drawings

FIG. 1 is a diagram illustrating an example of a data center in which servers are installed according to a first embodiment.
FIG. 2 is a block diagram illustrating a configuration of a wireless sensor according to the first embodiment.
FIG. 3A is a diagram illustrating an example of the information stored in a RAM.
FIG. 3B is a diagram illustrating an example of the information stored in a ROM.
FIG. 4 is a block diagram illustrating a configuration of a server according to the first embodiment.
FIG. 5 is a diagram illustrating a configuration example of a VM that is implemented by a hypervisor.
FIG. 6 is a diagram for explaining migration of VMs.
FIG. 7 is a flowchart illustrating the flow of a VM migration control process according to the first embodiment.

FIG. 8 is a flowchart illustrating the flow of a priority rank determining process of the VM migration control process.

FIG. 9 is a flowchart illustrating the flow of a migration process of the VM migration control process.

FIG. 10 is a diagram for explaining an example of migrating a VM across partitions according to a second embodiment.

FIG. 11 is a flowchart illustrating the flow of a migration process executed by a server according to the second embodiment.

FIG. 12 is a diagram for explaining an example of migrating a VM to a partition that is set across a plurality of servers according to a third embodiment.

FIG. 13 is a flowchart illustrating the flow of a migration process executed by the server according to the third embodiment.

FIG. 14 is a flowchart illustrating the flow of a VM remigration control process according to a fourth embodiment.

FIG. 15 is a diagram for explaining grouping of servers according to a fifth embodiment.

FIG. 16 is a block diagram illustrating a configuration of a server according to the fifth embodiment.

FIG. 17 is a flowchart illustrating the flow of a grouping process according to the fifth embodiment.

FIG. 18 is a flowchart illustrating the flow of a migration process according to the fifth embodiment.

FIG. 19 is a diagram illustrating a specific example of the grouping according to the fifth embodiment.

FIG. 20 is a diagram illustrating an example of a searching range.

FIG. 21 is a diagram illustrating an example of a computer system that executes a migration control program.

FIG. 22 is a diagram illustrating an arrangement example of servers in a data center.

FIG. 23 is a diagram illustrating the height of the space under the floor and the distance to an air-conditioner.

Description of Embodiments

Hereinafter, embodiments of a data center, an information processing system, an information processing device, a method for controlling the information processing device, and a control program will be described in detail with reference to the drawings. The present invention is not limited to these embodiments. The embodiments can be appropriately combined within such a range that processing contents do not conflict with each other.

First Embodiment

In a first embodiment, an example of a data center in which disclosed servers are installed, the configuration of devices installed in the data center, the flow of processes in the server, and the advantages of the embodiment will be described in order.

[Data Center (Overall Configuration)]

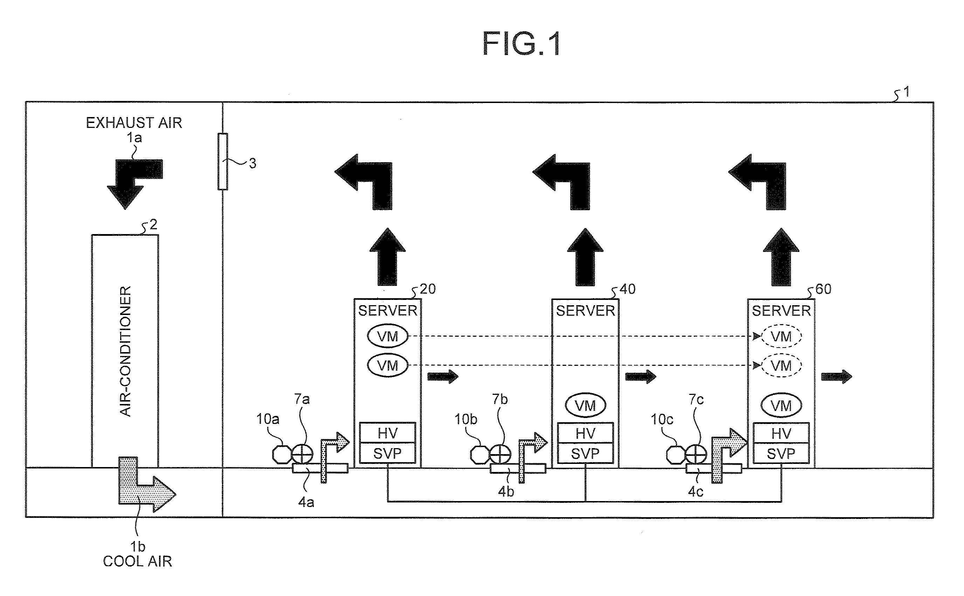

FIG. 1 is a diagram illustrating an example of a data center in which servers according to the first embodiment are installed. As illustrated in FIG. 1, a data center 1 includes an air-conditioner 2, an exhaust port 3, outlet ports 4a to 4c, and servers 20, 40, and 60. The number of devices such as the number of servers illustrated in FIG. 1, the installed locations of the devices, and the like are examples only, and the present invention is not limited to this.

The air-conditioner 2 takes in warm exhaust air 1a exhausted from the servers 20, 40, and 60 through the exhaust port 3. The air-conditioner 2 supplies cool air 1b which is the cooled air of the taken-in air to the space under the floor. In this example, although an underfloor air-conditioner that supplies the cool air 1b to the space under the floor has been exemplified, the air-conditioner is not limited to this, but an air-conditioner that is installed on the ceiling to supply cool air from the ceiling or the like may be used.

The outlet ports 4a to 4c are passages through which the cool air 1b supplied from the air-conditioner 2 to the space under the floor flows. An air volume sensor 7a that measures the volume of the cool air 1b flowing from the outlet port 4a and a wireless sensor 10a that is connected to the air volume sensor 7a to wirelessly communicate with other devices are installed in the outlet port 4a. Similarly, an air volume sensor 7b and a wireless sensor 10b are installed in the outlet port 4b, and an air volume sensor 7c and a wireless sensor 10c are installed in the outlet port 4c. The air volume sensor and the wireless sensor may be implemented in the same housing and may be implemented in separate housings.

The server 20 is an information processing device that takes in the cool air 1b from the outlet port 4a to cool internal electronic instruments and exhausts warmed air. Similarly, the server 40 is an information processing device that takes in the cool air 1b from the outlet port 4b to cool internal electronic instruments and exhausts warmed air. The server 60 is an information processing device that takes in the cool air 1b from the outlet port 4c to cool internal electronic instruments and exhausts warmed air.

Moreover, a hypervisor (HV) and a service processor (SVP) are mounted on each of the servers 20, 40, and 60. Each server operates a virtual machine (VM) which is a virtual computer using the mounted HV. These servers are communicably connected to each other via a network such as a local area network (LAN).

In such a condition, each server acquires the air volume measured by the air volume sensor installed in the outlet port through which the air that cools the subject device flows. Moreover, each server acquires the air volumes measured by the air volume sensors installed in the outlet ports through which the air that cools the other servers flows. After that, each server specifies another server cooled with a larger volume of air than the volume of air that cools the subject server based on the cooling air volume of the subject server and the cooling air volumes of the other servers and allows a virtual machine operating in the subject server to migrate to the specified other server.

For example, in the data center 1 illustrated in FIG. 1, the volume of air flowing from the outlet port 4a is the smallest, the volume of air flowing from the outlet port 4b is the next smallest, and the volume of air flowing from the outlet port 4c is the largest. In this case, the server 20 acquires the air volume "A" measured by the air volume sensor 7a installed in the outlet port 4a. Further, the server 20 acquires the air volume "B" measured by the air volume sensor 7b installed in the outlet port 4b and the air volume "C" measured by the air volume sensor 7c installed in the outlet port 4c.

Moreover, the server 20 compares the air volumes "A", "B", and "C" and determines that an air volume that is larger than the air volume "A" and is the largest is the air volume "C", that is, the volume of air taken in by the server 60 is the largest. After that, the server 20 executes a live migration (hereinafter, referred to as a "migration") that moves a VM operating in the subject device to the server 60.

That is, since each server migrates a VM to a server that is cooled by taking in a larger volume of air than the subject server, it is possible to put VMs together in the server that is cooled with a larger air volume. As a result, it is possible to improve the cooling efficiency of the servers installed in the data center.

[Configuration of Wireless Sensor]

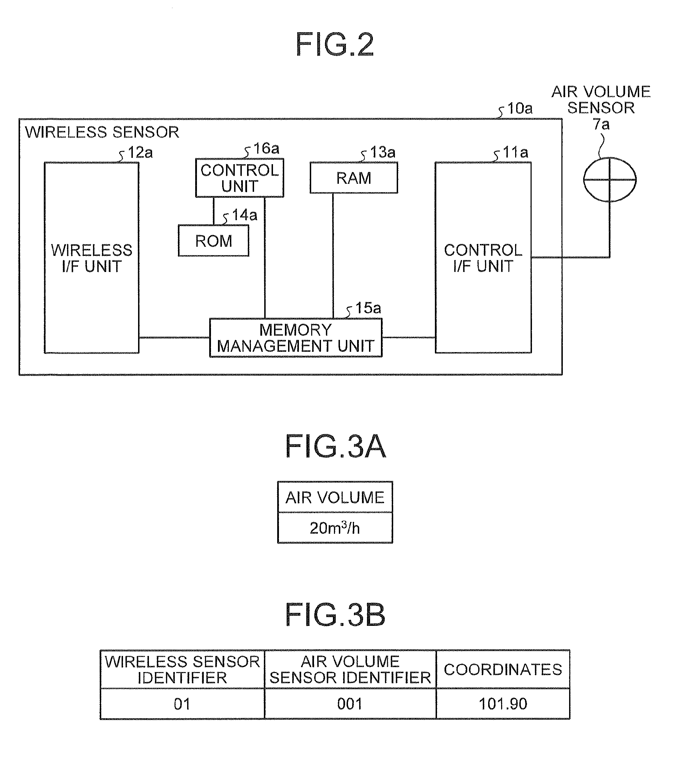

Next, the configuration of the wireless sensors 10a to 10c illustrated in FIG. 1 will be described. FIG. 2 is a block diagram illustrating the configuration of a wireless sensor according to the first embodiment. Since the wireless sensors 10a to 10c have the same configuration, the wireless sensor 10a will be described here.

As illustrated in FIG. 2, the wireless sensor 10a includes a control I/F unit 11a, a wireless I/F unit 12a, a RAM 13a, a read only memory (ROM) 14a, a memory management unit 15a, and a control unit 16a.

The control I/F unit 11a is an interface that is connected to the air volume sensor 7a via a serial port such as RS-232C or a bus such as an inter-integrated circuit (I2C), for example, and receives the air volume measured by the air volume sensor 7a. The air volume sensor 7a has the same configuration as the air volume sensors 7b and 7c, and is installed in the outlet port 4a so as to periodically or constantly measure the volume of air flowing from the outlet port 4a.

The wireless I/F unit 12a is an interface that controls wireless communication with the servers 20, 40, and 60 and other devices such as other wireless sensors according to wireless communication standards such as ZigBee (registered trademark), for example. The wireless I/F unit 12a transmits ultrasonic pulses together with radio frequency (RF) messages using radio frequencies during the wireless communication with other devices.

The RF messages transmitted from the wireless I/F unit 12a include "identifier for identifying the wireless sensor 10a", "identifier for identifying the air volume sensor 7a", "air volume measured by the air volume sensor 7a", and "address information of the air volume sensor 7a", for example. Besides these messages, position coordinates and the like that represent two-dimensional coordinates of the wireless sensor 10a, written to the RAM 13a, for example, are written to the RF messages by the control unit 16a described later.

Moreover, the wireless I/F unit 12a receives ultrasonic pulses together with RF messages from other devices. Moreover, the wireless I/F unit 12a can calculate the distance to a transmitter based on a time difference between the received time of the ultrasonic pulses and the received time of the RF messages. As another method, the wireless I/F unit 12a may transmit ultrasonic pulses, receive a reflected signal from a destination device, and calculate the distance to the transmitter based on the time elapsed until the reflected signal is received after the ultrasonic pulses are sent.

The wireless I/F unit 12a may have a global positioning system (GPS) reception function. When the wireless I/F unit 12a has a GPS reception function, the RF messages transmitted and received by the wireless I/F unit 12a may include position information or the like of the wireless sensor.

The RAM 13a is a main storage unit that stores data and programs used for various processes of the control unit 16a, and stores the air volume measured by the air volume sensor 7a and the like, for example. The ROM 14a is a read-only semiconductor memory and stores the position coordinates of the wireless sensor 10a designated in advance by an administrator, for example, an identifier for identifying the wireless sensor 10a, an identifier for identifying the air volume sensor 7a, and the like.

As an example, FIG. 3A is a diagram illustrating an example of the information stored in the RAM, and FIG. 3B is a diagram illustrating an example of the information stored in the ROM. As illustrated in FIG. 3A, the RAM 13a stores "20 $m^3$/h" as an "air volume" which is a variable value. As an example, as illustrated in FIG. 3B, the ROM 14a stores "01", "001", "(100.90)" as a "wireless sensor identifier", an "air volume sensor identifier", and "coordinates" which are fixed values. All of these items of information stored in the ROM 14a may be stored in the RAM 13a.

The "wireless sensor identifier" is an identifier for uniquely identifying the wireless sensor 10a, the "air volume sensor identifier" is an identifier for uniquely identifying the air volume sensor 7a connected to the wireless sensor 10a, and these identifiers are written by an administrator or the like. The "air volume" is the air volume measured by the air volume sensor 7a and is written by the control unit 16a. The "coordinates" are two-dimensional coordinates formed by the X-axis (horizontal axis) and Y-axis (vertical axis), measured by wireless communication and GPS and are written by the control unit 16a.

Returning to FIG. 2, the memory management unit 15a processes a memory access to the RAM 13a, requested from the control unit 16a. For example, the memory management unit 15a has a function of reading data stored in the RAM 13a, a function of writing data to the RAM 13a, and other functions.

The control unit 16a is a processor such as a central processing unit (CPU) that executes various processes of the wireless sensor 10a. For example, the control unit 16a writes the air volume acquired from the control I/F unit 11a to the RAM 13a or the like via the memory management unit 15a. Moreover, when transmitting RF messages via the wireless I/F unit 12a, the control unit 16a transmits various items of information stored in the ROM 14a, the RAM 13a, or the like by embedding the same in the messages. Further, upon receiving the RF messages via the wireless I/F unit 12a, the control unit 16a reads various items of information included in the RF messages and writes the same in the RAM 13a and the like.

[Configuration of Server]

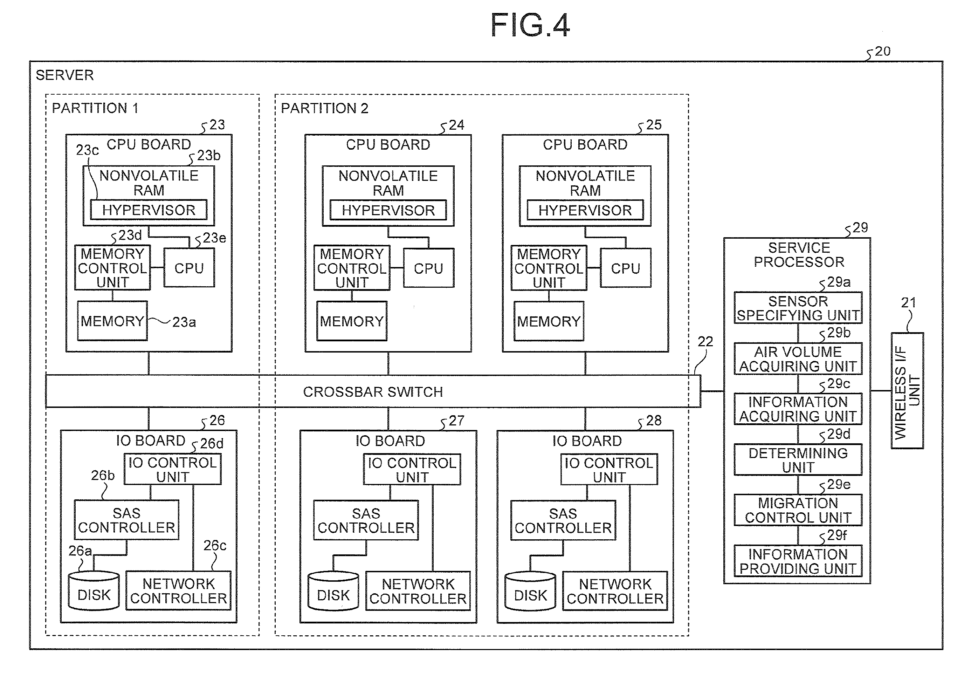

Next, the configuration of the servers 20, 40, and 60 illustrated in FIG. 1 will be described with reference to FIG. 4 which is a block diagram illustrating the configuration of the server according to the first embodiment. Since the servers 20, 40, and 60 have the same configuration, the server 20 will be described here.

As illustrated in FIG. 4, the server 20 includes a wireless I/F unit 21, a crossbar switch 22, CPU boards 23 to 25, 10 boards 26 to 28, and a service processor 29. Moreover, the CPU board 23 and the IO board 26 forms a partition 1, and the CPU boards 24 and 25 the 10 boards 27 and 28 form a partition 2. Here, a technique of dividing a server into a plurality of areas and operating OSs and applications in the respective divided areas to enable a plurality of systems to be established is called partitioning, and the respective divided regions are called partitions. The number of CPU boards, the number of IO boards, the formation of partitions, the number of partitions, and the like illustrated in the figure are examples only, and the present invention is not limited to this.

The wireless I/F unit 21 is an interface that controls wireless communication with other devices according to wireless communication standards such as ZigBee, for example, similarly to the wireless I/F unit 12a of the wireless sensor 10a. For example, the wireless I/F unit 21 receives RF messages and ultrasonic pulses from the respective wireless sensors 10a to 10c and outputs the same to the service processor 29. Here, the RF messages received by the wireless I/F unit 21 include "identifier for identifying a wireless sensor", "identifier for identifying an air volume sensor", "air volume measured by an air volume sensor", and "two-dimensional coordinates of a wireless sensor".

Moreover, the wireless I/F unit 21 transmits RF messages and ultrasonic pulses to the respective wireless sensors 10a to 10c. Here, the RF messages transmitted by the wireless I/F unit 21 include "identifier for identifying the server 20", "address information of the server 20", and "partition information of the server 20". These items of information exemplified here are written in RF messages by the service processor 29 or a hypervisor.

The crossbar switch 22 is a switch that dynamically selects the path of data exchanged between the service processor 29, the CPU boards 23 to 25, and the IO boards 26 to 28.

The CPU boards 23 to 25 are extension boards on which a processor for operating an operating system (OS) and a VM and various processing units are mounted. Since the CPU boards 23 to 25 have the same configuration, the CPU board 23 will be described here. The functional unit mounted on the CPU board described here is an example only, and the present invention is not limited to this.

As illustrated in FIG. 4, the CPU board 23 includes a memory 23a, a nonvolatile RAM 23b, a hypervisor 23c, a memory control unit 23d, and a CPU 23e. The memory 23a is a main storage unit that stores data and programs used for various processes of the CPU 23e, and stores information on a VM executed by the hypervisor 23c described below, data processed on the VM, and the like, for example. Examples of the information on the VM include the type of an OS being operated, an application program executed by the VM, and various items of data.

The nonvolatile RAM 23b is a memory that stores network information used by the VM that is executed by the CPU board 23 and a program of the hypervisor 23c that manages and controls the VM, and has a smaller capacity than the memory 23a. The information stored in the nonvolatile RAM 23b may be stored in a disk 26a described below.

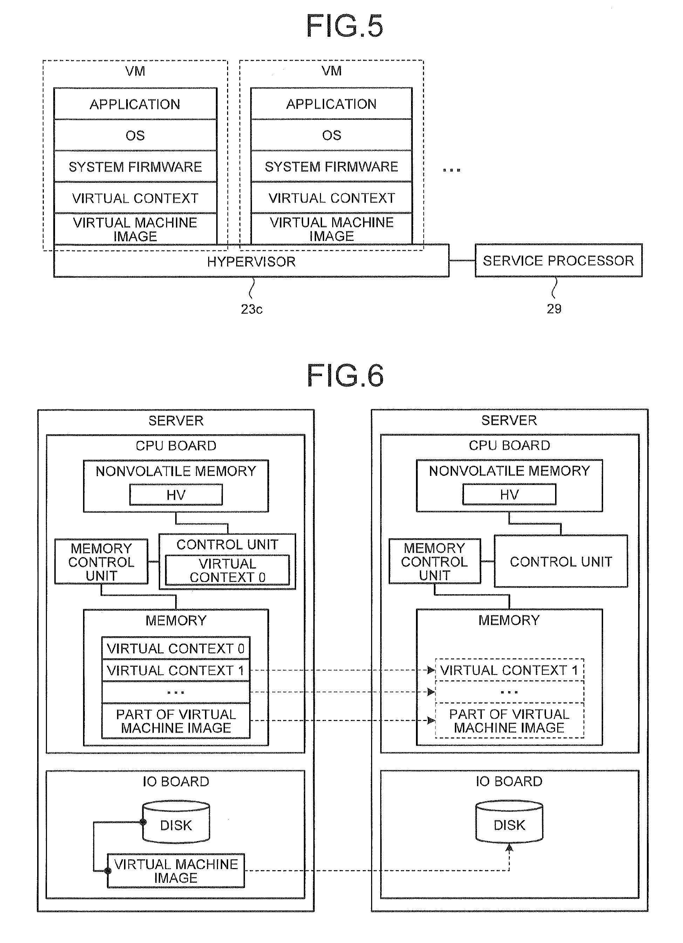

The hypervisor 23c is called a virtualization monitor, a virtual OS, and the like and is executed by the CPU 23e to form a plurality of logical partitions, manage identification information of the VM, and implement a VM operation. Here, the VM implemented by the hypervisor 23c will be described. FIG. 5 is a diagram illustrating a configuration example of the VM implemented by the hypervisor. As illustrated in FIG. 5, the hypervisor 23c manages "virtual machine image" and "virtual context" on the hypervisor 23c and executes "system firmware", "OS", and "application" to thereby operate a VM.

The "virtual machine image" is logical data that constitutes the VM, and includes a program that executes the VM and various items of data on the program. The "virtual context" is the smallest unit of a series of programs executed by the VM. The "system firmware" is firmware that controls various types of hardware in order to operate the VM. The "OS" is an operating system that is operated by the VM, and the "application" is software that operates on the VM.

Moreover, the hypervisor 23c collects information such as a CPU load rate or memory usage as the load information of each VM in operation and outputs and transmits the same to the service processor 29 and other servers. Further, the hypervisor 23c executes a migration to move the VM in operation to another server according to an instruction of the service processor 29.

Returning to FIG. 4, the memory control unit 23d is a memory controller that processes a memory access to the memory 23a, requested from the CPU 23e, and has a bus arbitration function or the like, for example. The CPU 23e is a processor that executes various types of control within the partition 1, and for example, executes the hypervisor 23c to operate the VM.

The IO boards 26 to 28 are connected to other CPU boards and IO boards via the crossbar switch 22, and are also connected to input/output devices and other servers. Since the IO boards 26 to 28 have the same configuration, the IO board 26 will be described here. The functional units mounted on the IO boards described here are examples only, and the present invention is not limited to this.

As illustrated in FIG. 4, the IO board 26 includes the disk 26a, a serial attached small computer system interface (SAS) controller 26b, a network controller 26c, and an IO control unit 26d. The disk 26a is a storage device having a larger capacity than the memory 23a and the nonvolatile RAM 23b and is a hard disk that stores configuration information or the like of the partition 1. Examples of the configuration information of the partition 1 include a disk capacity and the number of boards.

The SAS controller 26b is a serial interface that connects the disk 26a and the IO control unit 26d by a SAS to realize high-speed data transmission. The network controller 26c is an interface that controls communication with other devices, and for example, performs transfer of a VM according to a migration. The IO control unit 26d executes data access received from the CPU board 23 on the disk 26a via the SAS controller 26b. As a result, the CPU 23e and the hypervisor 23c of the CPU board 23 can write data to the disk 26a and read data from the disk 26a.

The service processor 29 is a processor that includes an internal memory and manages and controls partitions, VMs, and the like executed by the server 20 in a centralized manner. The service processor 29 includes a sensor specifying unit 29a, an air volume acquiring unit 29b, an information acquiring unit 29c, a determining unit 29d, a migration control unit 29e, and an information providing unit 29f.

The sensor specifying unit 29a calculates the distance between each wireless sensor and the subject device by wireless communication with the wireless sensors 10a to 10c installed in the respective outlet ports 4a to 4c and specifies an outlet port from which the cool air mainly taken in by the server 20 flows based on the calculated distance.

For example, the sensor specifying unit 29a controls the wireless I/F unit 21 to execute wireless communication with each of the wireless sensors 10a to 10c. Moreover, the sensor specifying unit 29a calculates the distance to each wireless sensor based on a difference in arrival time of the RF message and the ultrasonic pulse, a transmission speed of the RF message, and a transmission speed of the ultrasonic pulse for the respective wireless sensors. Further, the sensor specifying unit 29a specifies a wireless sensor of which the calculated distance is the smallest among the distances calculated for the respective wireless sensors and outputs the specified results to each control unit of the service processor 29. In the example of FIG. 1, the sensor specifying unit 29a specifies that the wireless sensor 10a is a sensor located at the smallest distance to the server 20.

As another method, a position detection method using received signal strength (reference literature: "position detection using radio signals", OKI Technical Review, October 2005/Issue 204, Vol. 72, No. 4) can be used. Specifically, the wireless sensors 10a to 10c output signals and the wireless sensors 10a to 10c measure the strength of the received signals. The sensor specifying unit 29a of each server estimates the positions of the wireless sensors using received signal strength acquired from the respective wireless sensors and a position detection algorithm that calculates a probability model of radio propagation characteristics under the actual environment and performs statistical estimation using a maximum likelihood method.

As a specific example, the sensor specifying unit 29a calculates a probability model of radio propagation characteristics in the actual environment. For example, the sensor specifying unit 29a obtains the relation between the distance between installed wireless sensors and the received signal strength. The wireless sensor may be moved. Moreover, the sensor specifying unit 29a calculates a conditional probability density function "p(P/r)" of received signal strength "P" at a distance "r" from a wireless sensor. The conditional probability density function "p(P/r)" can be expressed by Expressions (1) and (2). The conditional probability density function "p(P/r)" may be calculated in advance by a simulation or the like at the data center. Here, the left side of Expression (2) represents average received signal strength at the distance "r", and "C" and attenuation coefficient "$\alpha$" on the right side of Expression (2) are parameters determined when modeling the propagation environment.

[Expression 1]

$$p(P/r) = 1\Lambda(r)\exp(-P/\Lambda(r)) \qquad (1)$$

[Expression 2]

$$[\text{Expression 2}] \quad \Lambda(r) = Cr^{-\alpha} \qquad (2)$$

For example, it is assumed that the actual position of a wireless sensor (wireless tag) is $\theta = (x,y)$, the received signal strengths of signals transmitted from wireless sensors are represented by $P = (P_1, P_2, ..., \text{and } P_N)$, and the position of a detection target wireless sensor is $\theta$. In this case, the sensor specifying unit 29a expresses a probability that the received signal strengths of wireless sensors are P as a conditional probability density function "$p(P/\theta)$". Moreover, if the propagation paths of wireless sensors are independent, the sensor specifying unit 29a can express the conditional probability density function "$p(P/\theta)$" as a product of conditional probability density functions at respective positions of the wireless sensors as in Expression (3). Here, "$r_i$" in Expression (3) is the distance from a detection target wireless sensor to another wireless sensor that measured a received signal strength $P_i$ when the position of the detection target wireless sensor is $\theta$. The sensor specifying unit 29a uses a function "$L(\theta): = p(P/\theta)$" that considers Expression (3) as the function of the position $\theta$ of the wireless sensor as a likelihood function and estimates "$\theta$" that maximizes $L(\theta)$ as the position of the detection target wireless sensor.

[Expression 3]

$$p(P/\theta) = p(P_1/r_1)p(P_2/r_2)\cdots p(P_n/r_n) \qquad (3)$$

The air volume acquiring unit 29b acquires the air volume flowing from the specified outlet port, measured by an air volume sensor installed in the outlet port specified by the sensor specifying unit 29a. For example, in the case of FIG. 1, the air volume acquiring unit 29b acquires the air volume of the outlet port 4a specified by the sensor specifying unit 29a from the air volume sensor 7a and outputs the same to the respective control units of the service processor 29. As an example, the air volume acquiring unit 29b acquires "air volume of the air volume sensor 7a" included in the RF message that is received from the wireless sensor 10a connected to the air volume sensor 7a and stores the same in an internal memory or the like. As another example, the air volume acquiring unit 29b connects to the wireless sensor 10a installed in the outlet port 4a and reads the "air volume of the air volume sensor 7a" stored in the RAM 13a or the like of the wireless sensor 10a.

The information acquiring unit 29c acquires air volumes taken in by other servers, measured by the air volume sensors installed in other outlet ports and the load information (a CPU load rate, memory usage, and the like) of the other servers. In the example of FIG. 1, the information acquiring unit 29c acquires the air volume measured by the air volume sensor 7b via the LAN or the like from the server 40 installed near the outlet port 4b. Similarly, the information acquiring unit 29c acquires the air volume measured by the air volume sensor 7c via the LAN or the like from the server 60 installed near the outlet port 4c. Moreover, the information acquiring unit 29c acquires a CPU use rate, memory usage, and the like of the server 40 as the load information of the server 40. Similarly, the information acquiring unit 29c acquires a CPU use rate, memory usage, and the like of the server 60 as the load information of the server 60. Further, the information acquiring unit 29c outputs the respective items of acquired information to the respective control units such as the determining unit 29d.

As a method of acquiring the air volume, for example, the information acquiring unit 29c may acquire the air volume from the air volume sensor in each of the servers and may acquire the air volume from the wireless sensor. Specifically, the servers 40 and 60 specify the outlet ports nearest to the subject servers, acquire information of the air volume sensors from the wireless sensors installed in the specified outlet ports, and store the information in a memory or the like similarly to the server 20.

That is, the server 40 acquires the air volume from the air volume sensor 7b, and the server 60 acquires the air volume from the air volume sensor 7c. Thus, the information acquiring unit 29c may transmit a request for the air volume information to the service processor of each server via the LAN or the like to acquire the air volume and the load information. In this manner, each server can acquire the air volumes taken in by other servers and the load information in association by exchanging the air volume taken in by the subject device and the load information with other servers.

The determining unit 29d rearranges the air volumes of the respective servers that take in a larger air volume than the air volume acquired by the air volume acquiring unit 29b among the air volumes acquired by the information acquiring unit 29c and determines a priority rank so that a server having a larger air volume has a higher priority rank. Moreover, the determining unit 29d determines whether the server can operate a VM based on the load information of other servers acquired by the information acquiring unit 29c and the load information of a migration target VM in the order of the determined priority ranks. Further, the determining unit 29d outputs the information on the server, to which it is determined that the VM can migrate, to the migration control unit 29e.

For example, to describe in detail with reference to FIG. 1, the determining unit 29d determines the priority level in the order of the servers 60 and 40 since the air volume acquired from the server 60 is larger than the air volume acquired from the server 40. Subsequently, the determining unit 29d acquires a CPU use rate "30%" of the VM executed in the partition 1 of the subject server 20 from the hypervisor 23c. Moreover, the determining unit 29d acquires a CPU use rate "60%" acquired from the server 60 having the highest priority level and calculates an allowable CPU load "40%" from "100 (%) - 60 (%)". Moreover, the determining unit 29d determines the server 60 as a server that can operate the VM since the CPU use rate of the migration target VM is "30%" and the CPU load allowable by the migration candidate server 60 is "40%".

On the other hand, it is assumed that since the CPU use rate acquired from the server 60 having the highest priority level is "80%", the allowable CPU load is "20%". In this case, the determining unit 29d excludes the server 60 from migration destination candidates since the CPU use rate of the migration target VM is "30%" and the CPU load allowable by the migration target server 60 is "20 (%) (= 100 (%) - 80 (%))".

Moreover, the determining unit 29d performs the same process on the server 40 having the next highest priority level. For example, it is assumed that since the CPU use rate acquired from the server 40 having the next highest priority level is "20%", the allowable CPU load is "80 (%)". In this case, the determining unit 29d determines that the VM can migrate to the server 40 since the CPU use rate of the migration target VM is "30%" and the CPU load allowable by the migration target server 40 is "80 (%) (= 100 (%) - 20 (%)).

As a result, the determining unit 29d determines the server 40, to which it is determined that the VM can migrate, as a migration destination. When it is determined that it is not possible to migrate the VM to the server 40, the determining unit 29d determines that the VM will not migrate since there is no another server.

Although an example of making determination using the CPU use rate as the load information has been described, the present invention is not limited to this. For example, the memory usage may be used, both the CPU use rate and the memory usage may be used, and an optional combination of the items of load information may be used.

The migration control unit 29e performs a migration by allowing the VM to migrate to a server that the determining unit 29d determines that the server can operate the VM. In the above example, the migration control unit 29e transmits a VM migration instruction to migrate the VM to the server 60 to the hypervisor 23c in which the migration target VM operates. The hypervisor 23c having received the VM migration instruction migrates the VM to the server 60.

Here, a migration of the VM between servers will be described with reference to FIG. 6. The process described herein is executed by a hypervisor that operates on a migration target VM. As illustrated in FIG. 6, first, a migration source server reads a migratable virtual context that is not executed in a migration target VM among the virtual contexts corresponding to the migration target VM from a memory of the migration source server and copies the same in a memory of a migration destination server. Moreover, when an execution right is given to the copied virtual context, and the non-copied virtual contexts are released, the migration source server reads the virtual contexts from the memory of the migration source server and copies the same to the memory of the migration destination server. In this manner, the migration source server copies the virtual contexts stored in the memory and a portion of the virtual machine image to the memory of the migration destination server.

Subsequently, when the information on the VM stored in the memory is written to the migration destination server, the migration source server copies the virtual machine image stored in the disk of the migration source server and writes the same to the disk of the migration destination server. After that, the migration destination server loads the virtual machine image written to the disk of the migration destination server into the memory of the migration destination server. Alternatively, the migration destination server may load the virtual machine image into the memory by sharing the disk of the migration source server with the migration destination server via a network such as a LAN. As a result, the migration source server can migrate the VM that is operating in the subject device to the migration destination server.

Returning to FIG. 4, the information providing unit 29f transmits the air volume taken in by the subject server and the load information of the subject server to other servers via a network such as a LAN. For example, upon receiving an information acquisition request from other servers, the information providing unit 29f transmits the air volume acquired from the wireless sensor 10a and the load information acquired from the respective hypervisors of the respective partitions to the requestor via the LAN or the like. The load information may be the load information of each partition and may be the load information of the entire server 20, in which the respective items of information on the respective partitions are included.

[Process Flow]

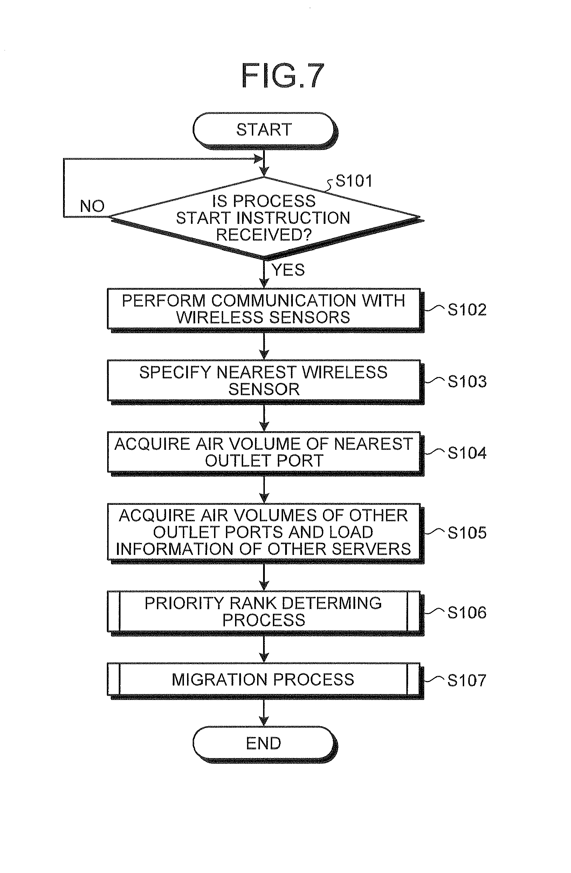

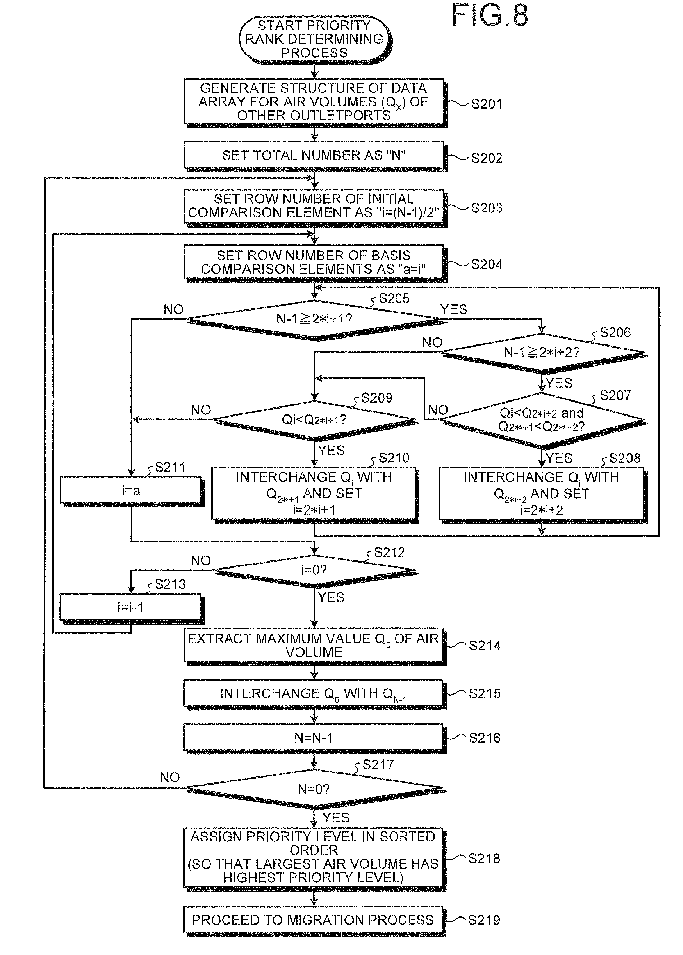

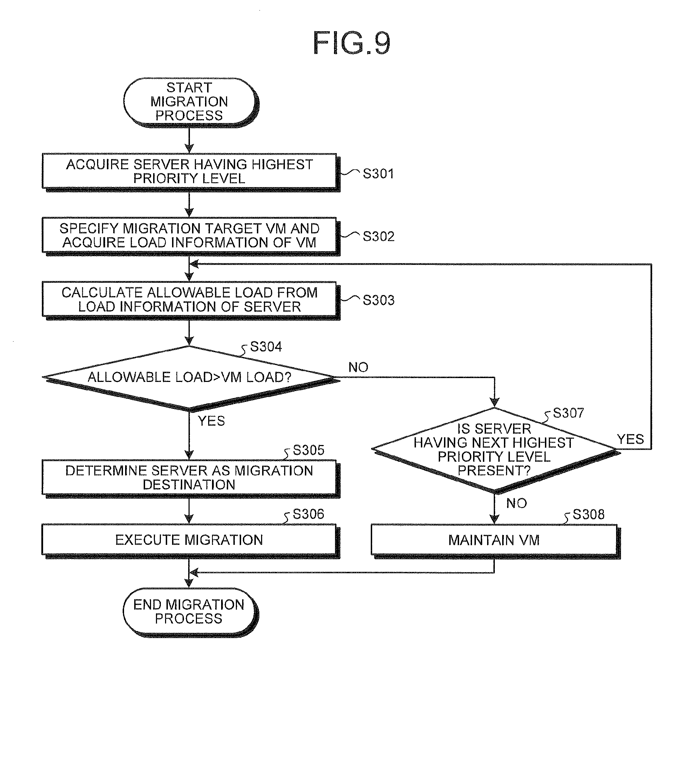

Next, the flows of the processes executed by the server 20 will be described with reference to FIGS. 7 to 9. FIG. 7 is a flowchart illustrating the flow of a VM migration control process according to the first embodiment, FIG. 8 is a flowchart illustrating the flow of a priority rank determining process of the VM migration control process, and FIG. 9 is a flowchart illustrating the flow of a migration process of the VM migration control process.

(Flow of VM Migration Control Process)

As illustrated in FIG. 7, upon receiving a process start instruction from an administrator terminal or the like (step S101: Yes), the sensor specifying unit 29a of the service processor 29 of the server 20 executes wireless communication with the respective wireless sensors (step S102).

Subsequently, the sensor specifying unit 29a specifies a wireless sensor nearest to the server 20 from the distance calculated based on the RF messages, the ultrasonic pulses, and the like received from the respective wireless sensors (step S103). That is, the sensor specifying unit 29a can specify a wireless sensor nearest to the server 20 to thereby specify the outlet port 4a flowing the cool air that is mainly taken in by the server 20, in which the wireless sensor is installed.

Moreover, the air volume acquiring unit 29b acquires the air volume (that is, the value of the air volume flowing from the outlet port 4a or the value of the air volume taken in by the server 20) measured by the air volume sensor 7a installed in the outlet port 4a specified by the sensor specifying unit 29a (step S104). In this case, the determining unit 29d collects the load information of a migration target VM from the hypervisor that operates the VM.

Subsequently, the information acquiring unit 29c and the determining unit 29d acquire the air volumes of the other outlet ports and the load information of the other servers (step S105) and execute a priority rank determining process of determining the priority level by determining the priority ranks of the migration destination candidate servers based on the acquired air volumes (step S106). After that, the determining unit 29d and the migration control unit 29e determine a migration destination server and execute a migration process of migrating the VM to the determined migration destination server (step S107).

(Flow of Priority Level Determining Process)

Next, the flow of the priority rank determining process executed in step S106 illustrated in FIG. 7 will be described. Although heapsort is described as an example, the present invention is not limited to this, and other sorting algorithms such as bubble sort may be used.

As illustrated in FIG. 8, the determining unit 29d generates an array of data for the air volumes ($Q_x$) of the respective servers, acquired by the information acquiring unit 29c (step S201) and sets the total number as N (step S202). Further, the determining unit 29d sets a row number of initial comparison elements as "i = (N-1)/2" (step S203). Subsequently, the determining unit 29d sets a row number of basis (parent) comparison elements as "a = i" (step S204). Here, "x" is a suffix that distinguishes the air volumes acquired from the respective air volume sensors, and there are three air volume sensors as illustrated in FIG. 1, "x" is 0, 1, or 2. As an example, $Q_0$ represents the air volume acquired by the air volume sensor 7a, $Q_1$ represents the air volume acquired by the air volume sensor 7b, and $Q_2$ represents the air volume acquired by the air volume sensor 7c.

After that, when (N-1) is equal to or larger than (2*i+1) (step S205: Yes), and (N-1) is equal to or larger than (2*i+2) (step S206: Yes), the determining unit 29d compares $Q_i$ with $Q_{2*i+2}$ and $Q_{2i+1}$ with $Q_{2i+2}$ (step S207). That is, when (N-1) $\geq$ (2i+1) and (N-1) $\geq$ (2i+2), the determining unit 29d executes step S207.

Moreover, when it is determined that $Q_{2*i+2}$ is larger than $Q_i$ and $Q_{z*i+2}$ is larger than $Q_{2*i+1}$ (step S207: Yes), the determining unit 29d interchanges $Q_i$ with $Q_{2*i+2}$ and substitutes "2*i+2" into "i" (step S208). After that, the flow returns to step S205, and the subsequent processes are executed.

On the other hand, when it is determined that $Q_{2*i+2}$ is smaller than $Q_i$ or $Q_{2*4+2}$ is smaller than $Q_{2*i+1}$ (step S207: No), the determining unit 29d compares $Q_i$ with $Q_{2*i+1}$ (step 5209). Moreover, when it is determined that $Q_{2*1+1}$ is larger than $Q_i$ (step S209: Yes), the determining unit 29d interchanges Qi with $Q_{2*i+1}$ and substitutes "2*i+1" into "i" (step S210). After that, the flow returns to step S205, and the subsequent processes are executed.

Moreover, when it is determined that $Q_{2*i+1}$ is smaller than $Q_i$ (step S209: No), the determining unit 29d substitutes "a" into "i" (step S211). When (N-1) is not equal to or larger than (2*i+2) (step S205: No), the determining unit 29d executes step S211 and the subsequent steps.

The determining unit 29d having executed step S211 determines whether i = 0 (step S212). When i $\neq$ 0 (step S212: No), the determining unit 29d substitutes (i-1) into "i" (step S213), returns to step S204, and executes the subsequent processes.

On the other hand, when i = 0 (step S212: Yes), the determining unit 29d extracts the largest value $Q_0$ from

the heap structure of the sorted air volumes $Q_x$ (step S214). Moreover, the determining unit 29d interchanges the maximum value $Q_0$ with $Q_{N-1}$ (step S215), sets new N as N-1 (step S216), and determines whether N = 0 (step S217).

Subsequently, when N ≠ 0 (step S217: No), the determining unit 29d returns to step S203 and executes the subsequent processes to reconstruct the heap structure. On the other hand, when N = 0 (step S217: Yes), the determining unit 29d determines priority ranks by assigning priority levels so that the priority rank increases in the sorted order and the largest air volume has the highest priority level (step S218). After that, the determining unit 29d proceeds to the migration process (step S219).

(Flow of Migration Process)

Next, the flow of the migration process executed in step S107 illustrated in FIG. 7 will be described. As illustrated in FIG. 9, the determining unit 29d acquires a server to which the highest priority level is assigned by the priority rank determining process illustrated in FIG. 8 as a migration destination candidate (step S301). Subsequently, the determining unit 29d specifies one migration target VM from VMs that operate in the subject server and acquires the load information of the VM from the hypervisor (step S302).

Moreover, the determining unit 29d calculates an allowable load from the load information of the migration destination candidate acquired by the information acquiring unit 29c (step S303). After that, when the allowable load is larger than the load of the migration target VM (step S304: Yes), the determining unit 29d determines the migration destination candidate as a migration destination server (step S305). Moreover, the migration control unit 29e outputs an instruction to migrate the VM to the migration destination server determined by the determining unit 29d to the hypervisor, whereby the migration of the VM is executed by the hypervisor (step S306).

On the other hand, when the allowable load is smaller than the load of the migration target VM (step S304: No), the determining unit 29d determines that the VM may not operate in the migration destination candidate and determines whether there is a server having the next high priority level (step S307).

When it is determined that there is the server having the next highest priority level (step S307: Yes), the determining unit 29d executes step S303 and the subsequent processes using the server having the next highest priority level as a new migration destination candidate. On the other hand, when it is determined that there is not the server having the next highest priority level (step S307: No), since there is no server to which the VM can migrate, the determining unit 29d maintains the VM without migrating the same (step S308).

[Advantageous Effect of First Embodiment]

According to the first embodiment, each server acquires the air volume measured by the air volume sensor installed in the outlet port through which the air that cools the subject device flows. Moreover, each server acquires the air volumes measured by the air volume sensors installed in the outlet ports through which the air that cools the other servers flows. Each server specifies another server cooled with a larger air volume than the air volume that cools the subject device and allows the VM that is to be operated in the subject server to migrate to the specified other server.

As a result, since each server migrates the VM to a server that takes in a larger air volume than the subject server to perform cooling, it is possible to put VMs together in the server that is cooled with a large air volume. As a result, it is possible to improve the cooling efficiency of the servers installed in the data center.

Moreover, according to the first embodiment, each server acquires the load information of other servers. Each server determines whether a server that is cooled with a larger air volume than the air volume taken in by the subject server is capable of operating the VM based on the load information of the other servers and the load information of the VM. Each server migrates the VM to the other server that is determined to be capable of operating the VM.

As a result, it is possible to migrate the VM based on the result of the determination on whether the migration destination candidate server can operate the migration target VM. That is, since the VM migrates only when the migration destination candidate server can operate the migration target VM as well as based on the air volume taken in by the migration destination candidate server, it is possible to suppress a decrease in the cooling efficiency of the migration destination server due to the migration of the VM and to suppress the inability to cool the migration destination server.

Moreover, according to the first embodiment, the distance between each wireless sensor to the subject server is calculated by wireless communication with the wireless sensors installed in the respective outlet ports, and the outlet port flowing the air that mainly cools the subject server is specified based on the calculated distance. Each server acquires the air volume measured by the air volume sensor installed in the specified outlet port.

As a result, by installing the disclosed wireless sensors in the respective outlet ports of a data center that is already built as well as when building a new data center, and providing functional units that execute the respective control processes to the servers, it is possible to improve the cooling efficiency of the respective servers of the data center. Thus, it is possible to reduce the cost of rebuilding an existing data center and to improve the cooling efficiency of the respective servers.

Moreover, according to the first embodiment, it is possible to improve the cooling efficiency of the respective servers without controlling the air-conditioner 2, that is without changing the amount of the cool air 1b supplied by the air-conditioner 2 in the data center 1. Thus, it is possible to reduce the cost as compared to the conventional technique of controlling the air-conditioner 2 to increase the amount of the supplied cool air 1b.

Second Embodiment

The disclosed server may migrate the VM across the partitions of the migration destination server. Thus, in the second embodiment, an example of migrating the VM across the partitions of the migration destination server will be described.

[Overall Configuration]

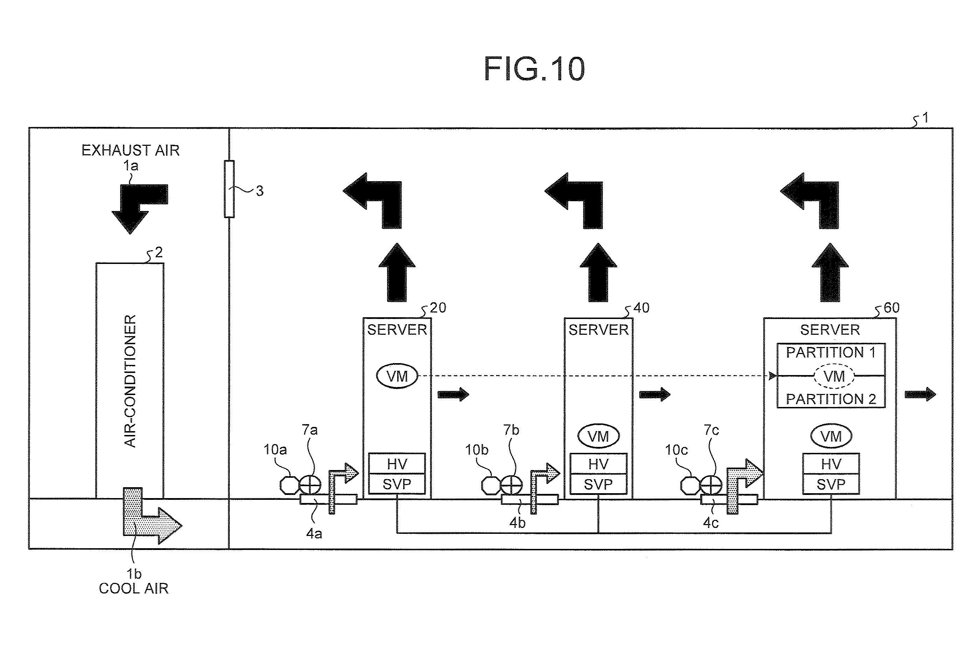

FIG. 10 is a diagram illustrating an example of migrating the VM across partitions according to the second embodiment. The data center 1 illustrated in FIG. 10 includes the air-conditioner 2, the exhaust port 3, the outlet ports 4a to 4c, and the servers 20, 40, and 60 similarly to FIG. 1. In this embodiment, it is assumed that the air volume increases in the order of the outlet ports 4c, 4b, and 4a. The number of devices such as the number of servers illustrated in FIG. 10, the installed locations and the like of the devices are examples only, and the present invention is not limited to this.

In such a condition, the server 20 acquires the air volume flowing from the outlet port 4a, measured by the air volume sensor 7a installed in the outlet port 4a flowing the cool air 1b that is taken in by the subject device. Moreover, the server 20 acquires the air volumes taken in by other servers, measured by the air volume sensors installed in the other outlet ports. After that, the server 20 determines the priority levels so that the priority rank increases in the order of the servers 60 and 40, determines a migration target VM among the VMs that operate in the subject server, and acquires the load information of the VM via a network such as a LAN.

Moreover, the server 20 acquires the configuration information of the partition 1 of the server 60 having the highest priority level and the load information of the partition 1. Subsequently, the server 20 calculates a load allowable for the partition 1 from the load information of the partition 1 and determines whether the VM can operate. In this embodiment, it is assumed that it is determined that the VM may not operate in the partition 1, that is the VM may not migrate to the partition 1.

In this case, the server 20 acquires the configuration information of the partition 2 of the server 60 and the load information of the partition 2 via a network such as a LAN. Moreover, the server 20 calculates a load allowable using both the partitions 1 and 2 based on the load information of the partition 1 and the load information of the partition 2 and determines whether the VM can operate. In this embodiment, it is assumed that it is determined that the VM can operate when both the partitions 1 and 2 are used.

Then, the server 20 determines both the partitions 1 and 2 of the server 60 as migration destinations. Moreover, the server 20 copies a virtual context to the partitions 1 and 2 of the server 60 and disposes a virtual machine image therein to set an environment in which the VM can operate across the partitions 1 and 2.

In this manner, according to the second embodiment, the server 20 acquires the load for each partition of the server 60, combines the acquired loads of the respective partitions, determines whether the VM can operate on the combined partition, and perform a migration of the VM when the VM can operate. Thus, it is possible to efficiently use the resources of the migration destination server.

[Process Flow]

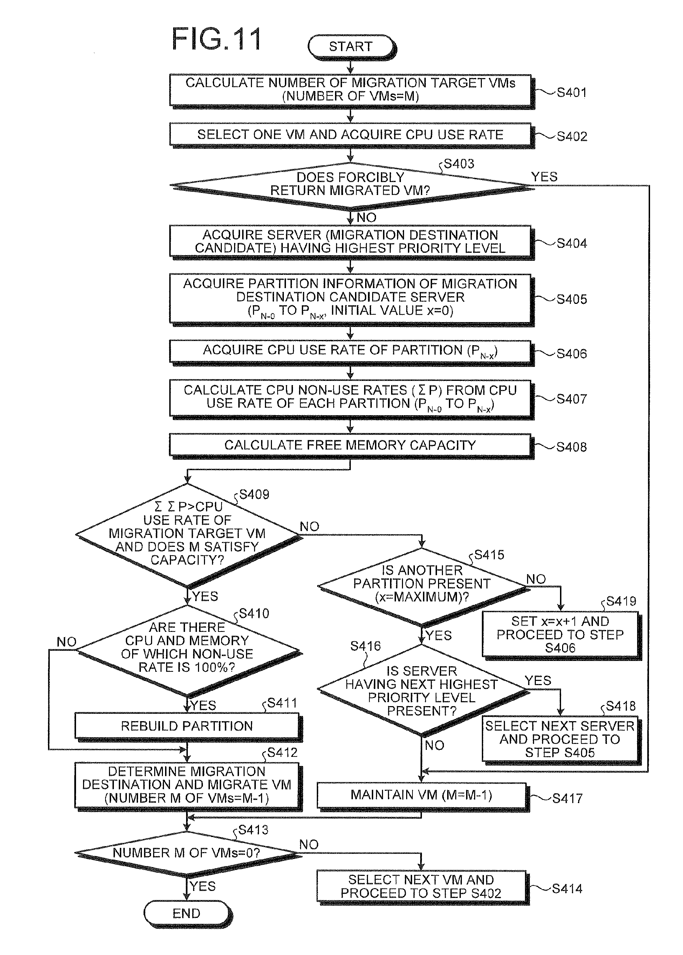

Next, the flow of the process according to the second embodiment will be described. FIG. 11 is a flowchart illustrating the flow of a migration process executed by the server according to the second embodiment. In this embodiment, it is assumed that the priority levels are determined by the server 20 so that the priority rank increases in the order of the servers 60 and 40.

As illustrated in FIG. 11, the determining unit 29d of the server 20 measures the number (M) of migration target VMs (step S401). Subsequently, the determining unit 29d selects one VM as a migration target and acquires the CPU use rate and the memory usage of the VM from the corresponding hypervisor (step S402).

Moreover, when an instruction to forcibly return the migrated VM to a migration source server is not received (step S403: No), the determining unit 29d acquires the server 60 as a server having the highest priority level (step S404). Subsequently, the determining unit 29d acquires partition information of the server 60 from the service processor of the server 60 which is a migration destination candidate (step S405). Here, it is assumed that the partition configuration includes $P_{N-0}$ to $P_{N-x}$, and the initial value is x = 0. Here, "N" appearing in "$P_{N-x}$" represents a physical server that exists in the data center and serves as a migration destination candidate, and "x" is the number of partitions formed in the physical server. As an example, when four partitions are formed in the server 40, the partition configuration includes

$P_{40-0}$, $P_{40-1}$, $P_{40-2}$, and $P_{40-3}$

After that, the determining unit 29d acquires the CPU use rate of a present target partition ($P_{N-x}$) from the service processor or the hypervisor of the server 60 (step S406). Moreover, the determining unit 29d calculates a CPU non-use rate ($\sum P$) using the acquired CPU use rate for each of the partitions ($P_{N-0}$ to $P_{N-x}$) acquired up to now (step S407). Further, the determining unit 29d acquires a free space of the memory from the service processor of the server 60 (step S408).

Moreover, the determining unit 29d executes step S409. That is, the determining unit 29d determines whether the sum ($\sum\sum P$) of the CPU non-use rate ($\sum P$) calculated for each partition is larger than the CPU use rate of the migration target VM and the memory usage of the server 60 satisfies the VM usage.

Subsequently, when the sum ($\sum\sum P$) of the non-use rate is larger than the CPU use rate of the migration target VM and the memory usage of the server 60 satisfies the VM usage (step S409: Yes), the determining unit 29d executes step S410. That is, the determining unit 29d determines whether a CPU and a memory of which the non-use rate is 100% are present in the server 60 that is determined as a migration destination.

Moreover, when it is determined that the CPU and the memory of which the non-use rate is 100% are present in the server 60 (step S410: Yes), the determining unit 29d transmits a partition rebuild request to the service processor of the server 60 so that the CPU and the memory can be used (step S411). After that, the determining unit 29d determines the partition rebuilt by the server 60 as a migration destination, and the migration control unit 29e migrates the VM to the migration destination determined by the determining unit 29d (in this example, the partition rebuilt by the server 60).

In this case, the migration control unit 29e calculates "M-1" by subtracting "1" from the number of VMs and determines whether M = 0 using the calculated "M-1" as a new number "M" of VMs (step S413). Moreover, when M = 0 (step S413: Yes), the process ends. On the other hand, when M ≠ 0 (step S413: No), that is, when a VM is still operating in the server 20, the migration control unit 29e determines the next VM as a migration target and executes step S402 and the subsequent processes (step S414).

On the other hand, when it is determined in step S410 that the CPU and the memory of which the non-use rate is 100% are not present in the server 60 (step S410: No), the determining unit 29d determines the partitions ($P_{N-0}$ to $P_{n-x}$) which are the present migration destination targets as migration destinations and executes step S412 and the subsequent processes.

Moreover, when it is determined in step S409 that the sum ($\sum\sum P$) of the non-use rate is smaller than the CPU use rate of the migration target VM, or the memory usage of the server 60 does not satisfy the VM usage (step S409: No), the determining unit 29d executes step S415. That is, the determining unit 29d determines whether there is another partition in the server 60, that is, whether the present "x" is the maximum value.

When it is determined in step S415 that there is no another partition in the server 60 (step S415: Yes), the determining unit 29d determines whether there is a server having the next highest priority level (step S416). When it is determined that the server having the next highest priority level is not present (step S416: No), the determining unit 29d maintains the present migration target VM in the subject server to allow the VM to continue operations without migrating the same (step S417). After that, the determining unit 29d decreases the number "M" of VMs to "M-1" and then executes step S413 and the subsequent processes.

When it is determined that the server having the next highest priority level is present (step S416: Yes), the determining unit 29d changes "N" in "$P_{N-0}$" to "$P_{N-x}$" to the next server using the server as a migration destination candidate and executes step S405 and the subsequent processes (step S418). That is, the determining unit 29d determines that it is not possible to operate the VM even when the CPU non-use rates of the respective partitions of the server 60 are summed up. Then, the determining unit 29d sums up the CPU non-use rates of the respective partitions of the server having the next highest priority level and determines whether the migration of the VM is possible.

When it is determined that there is another partition in the server 60 (step S415: No), the determining unit 29d increments "x'" to "x = x + 1" and executes step S406 and the subsequent processes (step S419). That is, the determining unit 29d acquires the CPU use rate and the like of the next partition and determines whether the migration target VM can operate in the partition ($P_{N-0}$ to $P_{N-X}$).

Moreover, when it is determined in step S403 that the migrated VM is to be forcibly returned to the migration source server (step S403: Yes), the determining unit 29d executes step S417 and the subsequent processes. That is, the determining unit 29d excludes the present target VM from the migration targets and executes the above processes on the next VM.

[Advantageous Effect of Second Embodiment]

According to the second embodiment, each server acquires the load information of each of the partitions formed in other servers. Each server calculates the load allowable in each partition from the load information of the respective partitions of the other servers and specifies a combination of partitions in which the VM can migrate and operate based on the calculated load allowable in the respective partitions. Each server migrates the VM to the specified combination of partitions of the specified other server.

As a result, the server which is a VM migration source can sum up the CPUs and memories that are not used in the respective partitions of the migration destination server and create an environment in which the migration target VM can operate. Thus, it is possible to efficiently use the hardware resources of the migration destination server. Further, since the CPUs and memories that are not used by the migration destination server are used, it is possible to prevent an increase in the load of the migration destination server even after the migration of the VM.

Third Embodiment

Incidentally, in the second embodiment, although an example of migrating the VM so as to operate across a plurality of partitions set in one migration destination server has been described, the present invention is not limited to this. For example, the disclosed server may migrate the VM so as to operate on a partition that is set across a plurality of servers. Thus, in the third embodiment, an example of migrating the VM so as to operate on a partition set across a plurality of servers will be described.

[Overall Configuration]

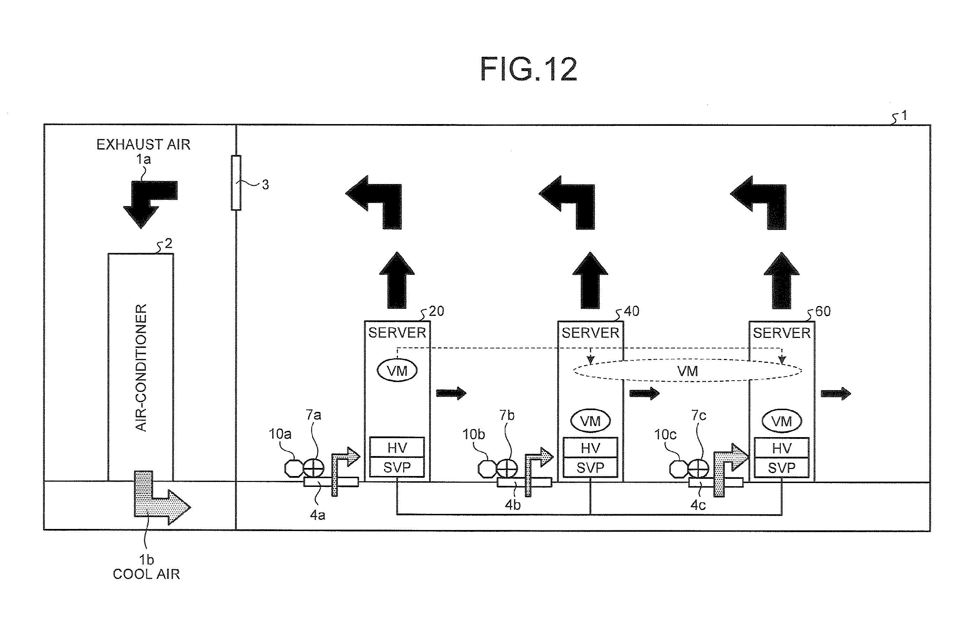

FIG. 12 is a diagram illustrating an example of migrating a VM to a partition set across a plurality of servers according to the third embodiment. The data center 1 illustrated in FIG. 12 includes the air-conditioner 2, the exhaust port 3, the outlet ports 4a to 4c, the servers 20, 40, and 60 similarly to FIG. 1.

In such a condition, the server 20 acquires the air volume of the outlet port 4a, measured by the air volume sensor 7a installed in the outlet port 4a flowing the cool air 1b that is mainly taken in by the subject device. Moreover, the server 20 acquires the air volumes that are mainly taken in by other servers, measured by the air volume sensors installed in the other outlet ports. After that, the server 20 determines priority levels so that the priority rank increases in the order of the server 60 and 40, determines a migration target VM among the VMs that operate in the subject server, and acquires the load information of the VM.

Moreover, the server 20 calculates the load allowable solely by the server 60 from the load information of the server 60 having the highest priority level. Subsequently, the server 20 compares the load allowable solely by the server 60 and the load of the migration target VM and determines whether the server 60 solely can operate the migration target VM. In this embodiment, it is assumed that it is determined that the server 60 may not solely operate the migration target VM.

Subsequently, the server 20 calculates the load allowable solely by the server 40 from the load information solely of the server 40 having the next highest priority level. Subsequently, the server 20 compares the load allowable solely by the server 40 and the load of the migration target VM and determine whether the server 40 solely can operate the migration target VM. In this embodiment, it is assumed that it is determined that the server 40 may not solely operate the migration target VM.

Then, the server 20 determines whether the sum of the load allowable by the server 60 and the load allowable by the server 40 is larger than the load of the VM. That is, the server 20 determines whether the VM can migrate to a partition that is set across the servers 60 and 40.

Moreover, when the sum of the load allowable by the server 60 and the load allowable by the server 40 is larger than the load of the migration target VM, the server 20 determines that the VM can migrate and determines the partition set across the servers 60 and 40 as the migration destination. After that, the server 20 copies the virtual context and the virtual machine image to the servers 60 and 40 and migrates the VM to the partition set across both servers.

In this embodiment, although an example of determining whether the server 20 can operate the VM in descending order of priority level and determining whether the VM can migrate to a partition set across the servers when it is determined that all servers cannot operate the VM has been described, the present invention is not limited to this. For example, the server 20 may specify a combination of servers that can operate the VM from the servers that take in a larger air volume than the air volume taken in by the subject server when it is designated in advance by an administrator or the like and migrate the VM to a partition set across the specified servers. The number of servers across which the partition is set may be at least 2.

[Process Flow]

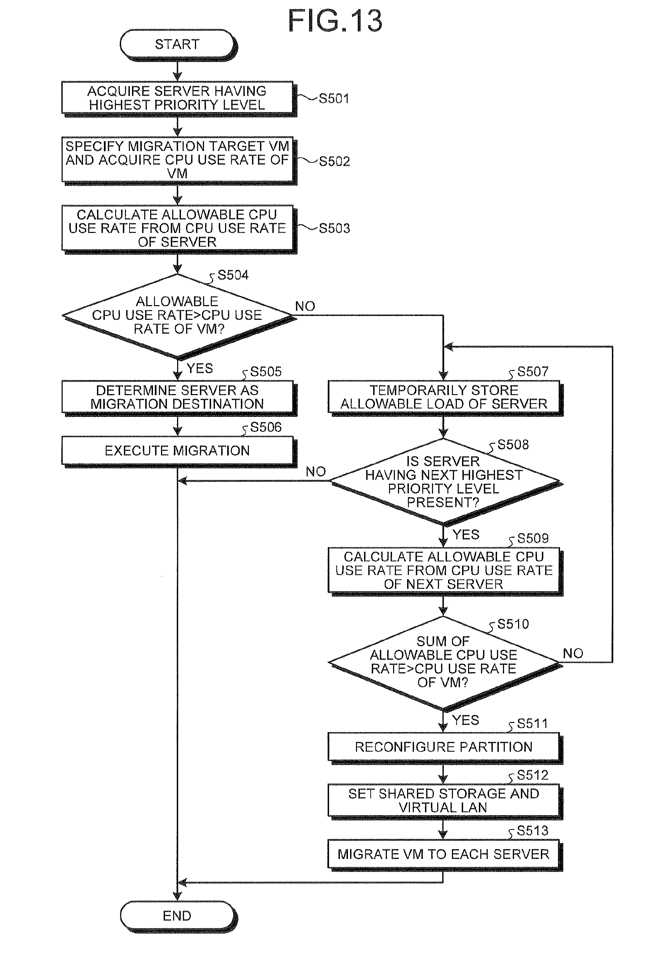

Next, the flow of the process according to the third embodiment will be described. FIG. 13 is a flowchart illustrating the flow of a migration process executed by the server according to the third embodiment. In this embodiment, it is assumed that the priority levels are determined by the server 20 so that the priority rank increases in the order of the server 60 and 40.

As illustrated in FIG. 13, the determining unit 29d of the server 20 acquires a server to which the highest priority level is assigned as a migration destination candidate (step S501). Subsequently, the determining unit 29d specifies the migration target VM and acquires the CPU use rate of the VM from the corresponding hypervisor (step S502).

Subsequently, the determining unit 29d calculates the allowable CPU use rate from the CPU use rate of the partition that operates on the migration destination candidate server (step S503) and determines whether the CPU use rate allowable by the partition of the server is larger than the CPU use rate of the migration target VM (step S504).

Moreover, when it is determined that the CPU use rate allowable by the partition of the migration destination candidate server is larger than the CPU use rate of the migration target VM (step S504: Yes), the determining unit 29d determines the partition of the server as a migration destination (step S505). After that, the migration control unit 29e migrates the migration target VM to the partition of the determined migration destination server (step S506).

On the other hand, when it is determined that the CPU use rate allowable by the partition of the migration destination candidate server is smaller than the CPU use rate of the migration target VM (step S504: No), the determining unit 29d temporarily stores the CPU use rate allowable by the partition of the migration destination candidate server in the memory or the like of the determining unit 29d (step S507). Subsequently, the determining unit 29d determines whether a server having the next highest priority level is present (step S508) and ends the process when the server is not present (step S508: No).

On the other hand, when it is determined that the server having the next highest priority level is present (step S508: Yes), the determining unit 29d sets the partition set in the server as a new migration destination candidate and calculates the CPU use rate allowable by the partition of the server which is the new migration destination candidate from the CPU use rate of the server (step S509).

Subsequently, the determining unit 29d determines whether the sum of the CPU use rate allowable by the partition of the previous migration destination candidate server and the CPU use rates allowable by the partitions set to the new migration destination candidate servers is larger than the CPU use rate of the VM which is the migration target (step S510).

When it is determined that the sum of the CPU use rates allowable by the respective partitions set to the previous migration destination candidate server and the new migration destination candidate server is larger than the CPU use rate of the migration target VM (step S510: Yes), the determining unit 29d reconfigures the partition so as to extend across the previous migration destination candidate server and the new migration destination candidate server (step S511). After that, the determining unit 29d determines the partition set across both servers as a migration destination and executes step S512. That is, the determining unit 29d transmits a request to set a shared storage and a virtual LAN to the partition that is set across both servers.

After that, the migration control unit 29e copies the virtual context and the virtual machine image to the partition that is set across both servers and migrates the migration target VM so as to operate using the shared storage and the virtual LAN set to the partition (step 5513).

On the other hand, when it is determined that the sum of the CPU use rate allowable by the partition set across both servers is smaller than the CPU use rate of the migration target VM (step S510: No), the determining unit 29d returns to step S507 and executes the process using the partition of the server having the next highest priority level as a new migration destination candidate. The process of FIG. 13 is executed on the VMs that operate in the migration source server.

[Advantageous Effect of Third Embodiment]

According to the third embodiment, each server calculates the load allowable by the respective partitions of other servers from the load information of the partitions of the servers other than the subject server and specifies a combination of partitions of the servers that can operate the VM based on the calculated load allowable by the respective partitions of the server. Each server reconfigures a partition so as to extend across a plurality of servers of the specified combination with respect to the partitions of the plurality of servers and migrates the VM so that the VM operates in the reconfigured partition extending across the plurality of servers. As a result, even when it is not possible to operate the VM in the partition of a sole server, since it is possible to migrate the VM using the partition set across the plurality of servers, it is possible to improve the cooling efficiency while effectively using the resources of the respective servers.

Fourth Embodiment

The disclosed server may return the VM that already has migrated to the subject server by remigrating the VM from the migration destination server to the subject server which is the migration source. Thus, in the fourth embodiment, an example of remigrating the VM that has migrated from the subject server to operate the VM again in the subject server will be described.

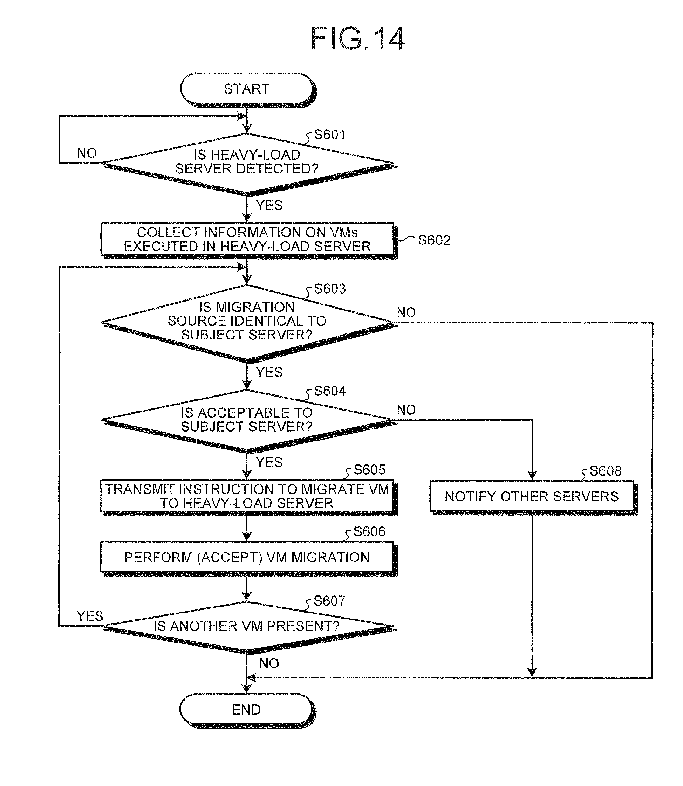

FIG. 14 is a flowchart illustrating the flow of a VM remigration control process according to the fourth embodiment. As illustrated in FIG. 14, upon detecting a heavy-load server by periodic communication or the like with other servers via a network such as a LAN (step S601: Yes), the migration control unit 29e of the server 20 collects the information on VMs executed in the heavy-load server (step S602). For example, the migration control unit 29e detects a server in which the CPU use rate collected periodically has reached a predetermined value or more as the heavy-load server.

Moreover, the migration control unit 29e determines whether a VM that has migrated from the subject server is present in the VMs that operate in the heavy-load server from the received VM information, that is whether the migration source of the VM is the subject server (step S603).

For example, the migration control unit 29e periodically receives the load information from other servers via a network such as a LAN or periodically monitors the load using monitoring software or the like. Moreover, the migration control unit 29e transmits a request to provide the VM to the heavy-load server. After that, in response to the request, the migration control unit 29e specifies the migration source server from the information such as an identifier included in the VM information received from the heavy-load server.

After that, when it is determined that the VM of which the migration source is the subject server is present in the VMs that operate in the heavy-load server (step S603: Yes), the migration control unit 29e executes step S604. That is, the migration control unit 29e acquires the load information of the subject server and determines whether the VM can be accepted, that is, the VM can operate in the subject server.

When it is determined that it is possible to accept the VM of which the migration source is the subject server (step S604: Yes), the migration control unit 29e transmits an instruction to migrate the VM to the heavy-load server (step S605) and then operate the migrated VM in the subject server (step S606). Moreover, when it is determined that the VM of which the migration source is the subject server among the VMs other than the migrated VM is not present in the heavy-load server (step S607: Yes), the migration control unit 29e ends the process. On the other hand, when it is determined that the VM of which the migration source is the subject server among the VMs other than the migrated VM is present in the heavy-load server (step S607: No), the migration control unit 29e executes step S603 and the subsequent processes.

Moreover, when it is determined in step S604 that it is not possible to accept the VM of which the migration source is the subject server (step S604: No), the migration control unit 29e transmits an instruction to migrate the VM to the other servers (step S608). Moreover, when it is determined in step S603 that the VM of which the migration source is the subject server is not present in the VMs that operate in the heavy-load server (step S603: No), the migration control unit 29e ends the process.

[Advantageous Effect of Fourth Embodiment]

According to the fourth embodiment, when the processing load of the other servers to which the VM has migrated has reached a predetermined value or more, each server transmits a request to remigrate the VM to the subject server to the other servers. As a result, even when the migration destination server has a heavy load and the cooling efficiency has decreased due to the migrated VM, it is possible to remigrate the VM to the migration source server. Thus, even after the migration of the VM, it is possible to distribute the VMs to the respective servers in the data center so as to improve the cooling efficiency.

Fifth Embodiment

In the first to third embodiments, although an example of determining the priority ranks of the migration destination candidates of the VM according to the air volume from the outlet port installed so as to correspond to each server has been described, the present invention is not limited to this. For example, the respective servers may be grouped based on the direction of the cool air flowing from the outlet port, the air volume of the cool air mainly taken in by the server, and the like, and then, the priority rank may be determined.

Thus, in the fifth embodiment, an example of determining the priority rank after grouping the respective servers will be described. In the fifth embodiment, an overall configuration, a process flow, and advantages of the fifth embodiment will be described in order.

[Overall Configuration]

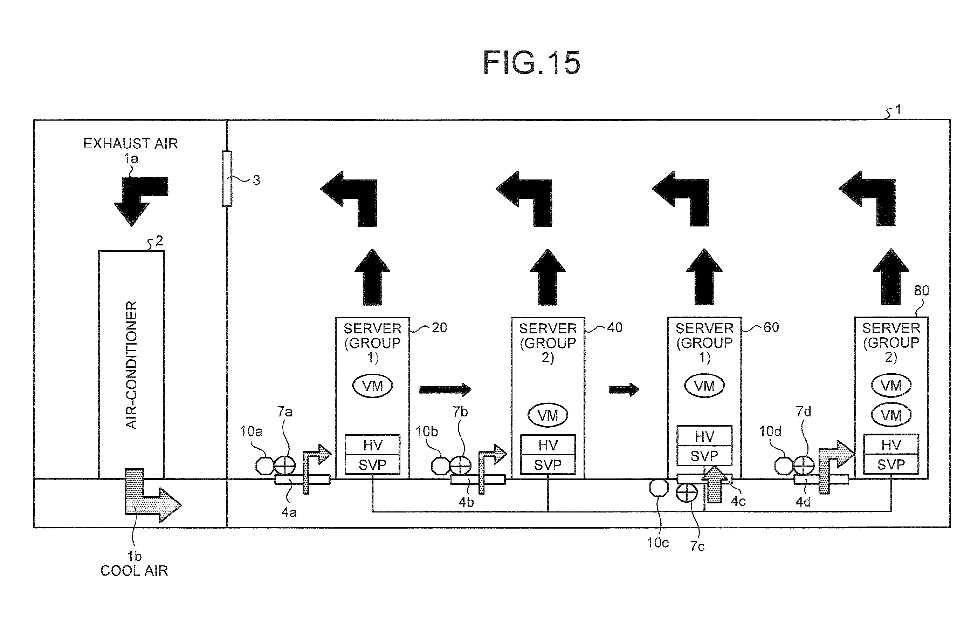

FIG. 15 is a diagram for explaining grouping of servers according to the fifth embodiment. As illustrated in FIG. 15, the data center 1 includes the air-conditioner 2, the exhaust port 3, the outlet ports 4a to 4d, and the servers 20, 40, 60, and 80.

The air-conditioner 2 has the same function as the first embodiment. The outlet ports 4a to 4d may have a different arrangement from the first embodiment and have the same function as the outlet ports described in the first embodiment. Moreover, the air volume sensors 7a to 7d and the wireless sensors 10a to 10d installed in the outlet ports 4a to 4d may have a different arrangement from the first embodiment and have the same function as the

first embodiment.

The server 20 is an information processing device that mainly takes in the cool air from the corresponding outlet port 4a to cool internal electronic instruments and exhaust warmed air. Similarly, the server 40 is an information processing device that mainly takes in the cool air from the corresponding outlet port 4b to cool internal electronic instruments and exhaust warmed air. The server 60 is an information processing device that mainly takes in the cool air from the corresponding outlet port 4c under the subject device to cool internal electronic instruments and exhaust warmed air. The server 80 is an information processing device that mainly takes in the cool air from the corresponding outlet port 4d to cool internal electronic instruments and exhaust warmed air.

In such a condition, the server 20 classifies the servers in the data center 1 into predetermined groups based on the direction of the cool air flowing from the outlet port, the position of the outlet port, the positional relation between the position of an intake port of the server that takes in the cool air, the position of the exhaust port that exhausts warm air, and the position of the wireless sensor, and the like. Specifically, the respective servers are grouped based on whether the server is a server that mainly takes in the cool air from the outlet port or a server that also takes in the exhaust air from the other servers. Moreover, a server that mainly takes in the cool air from the outlet port is classified to a first group and a server that also takes in the exhaust air from the other servers is classified to a second group, and priority level is assigned so that the first group has a higher priority level than the second group. After that, similarly to the first embodiment, the server 20 specifies a server to which the VM can migrate based on the assigned priority level and migrates the migration target VM to the specified server.

[Configuration of Server]

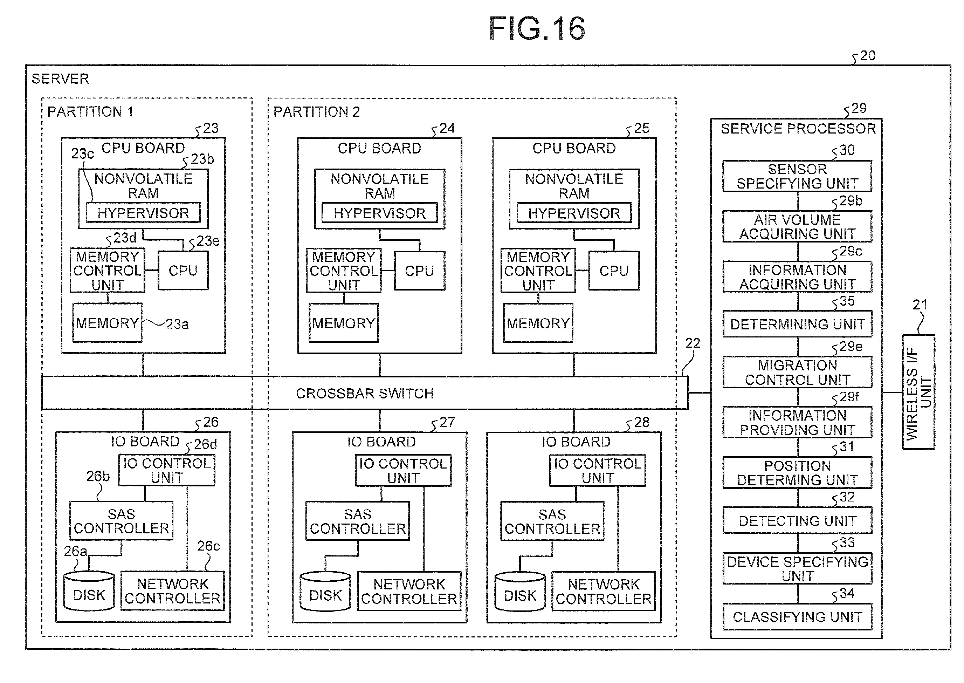

Next, the configuration of the servers 20, 40, 60, and 80 illustrated in FIG. 15 will be described. FIG. 16 is a block diagram illustrating the configuration of the server according to the fifth embodiment. Since the servers 20, 40, 60, and 80 have the same configuration, the server 20 will be described herein.

As illustrated in FIG. 16, the server 20 includes the wireless I/F unit 21, the crossbar switch 22, the CPU boards 23 to 25, the IO boards 26 to 28, and the service processor 29. Moreover, the CPU board 23 and the IO board 26 forms a partition 1, and the CPU boards 24 and 25, the IO boards 27 and 28 form a partition 2. The number of CPU boards, the number of IO boards, the formation of partitions, the number of partitions, and the like illustrated in the figure are examples only, and the present invention is not limited to this.

Here, since the wireless I/F unit 21, the crossbar switch 22, the CPU boards 23 to 25, and the IO boards 26 to 28 have the same functions as the first embodiment, the detailed description thereof will not be provided. Moreover, since the air volume acquiring unit 29b, the information acquiring unit 29c, the migration control unit 29e, and the information providing unit 29f included in the service processor 29 have the same functions as the first embodiment, the detailed description thereof will not be provided.

In this embodiment, a sensor specifying unit 30, a position determining unit 31, a detecting unit 32, a device specifying unit 33, a classifying unit 34, and a determining unit 35 having different functions from the first embodiment will be described.

The sensor specifying unit 30 specifies the coordinates of the respective wireless sensors using wireless communication with the wireless sensors installed in the respective outlet ports and specifies an outlet port that flows the cool air that mainly cools the subject server 20 based on the coordinates of the respective specified wireless sensors and the coordinates of the subject server 20.

For example, when the position coordinates of the respective servers are determined in advance when designing the data center, the sensor specifying unit 30 acquires the position coordinates of the wireless sensor from the RF messages received from the respective wireless sensors. Moreover, the sensor specifying unit 30 compares the position coordinates of the subject server 20 with the acquired position coordinates of the wireless sensor to thereby specify the nearest wireless sensor 10a installed so as to correspond to the subject server 20.

Similarly, the sensor specifying unit 30 acquires the position coordinates of the respective servers and the position coordinates of the wireless sensors nearest to the respective servers from the servers 40 to 80. Moreover, the sensor specifying unit 30 specifies the positional relation between the respective wireless sensors and the corresponding servers to thereby specify the positional relation between the server and the outlet port that flows the cool air that is mainly taken in by each server.

As another method, a reference wireless sensor may be installed at the position coordinates [0.0], and each wireless sensor may communicate with the reference wireless sensor to thereby calculate the distance to the reference wireless sensor. Further, each wireless sensor may communicate with other wireless sensors to thereby calculate the coordinate from the reference wireless sensor. That is, each wireless sensor can estimate the position coordinates of the subject sensor by communicating with the reference wireless sensor and other wireless sensors to calculate the distances from the respective sensors. Thus, the sensor specifying unit 30 can specify the outlet port nearest to the subject server by acquiring the position coordinates estimated in this manner from the wireless sensor and comparing the same with the position coordinates of the subject server.

The position determining unit 31 determines whether the position of each outlet port is under the server based on the coordinates of each wireless sensor, specified by the sensor specifying unit 30. For example, the position determining unit 31 specifies the positional relation between the wireless sensor and the subject server from the coordinates of the wireless sensor 10a acquired by the sensor specifying unit 30 and the position coordinates of the subject server 20 and determines whether the outlet port 4a in which the wireless sensor 10a is installed is positioned under the subject server 20 or at a position such as in front or at the rear other than under the server 20. Similarly, the position determining unit 31 specifies the positions of the respective outlet ports in relation to the respective servers from the position coordinates of the servers acquired from the respective servers and the position coordinates of the wireless sensors acquired by the sensor specifying unit 30. Moreover, the position determining unit 31 outputs the specified positions of the respective servers and the positional relation with the respective wireless sensors to the detecting unit 32, the device specifying unit 33, and the classifying unit 34. Here, when two-dimensional coordinates are used, for example, "whether the outlet port is positioned under the server" can be detected using a method of determining whether the value of the X and Y coordinates of a wireless sensor is within a predetermined range from the specified position of the server or whether the horizontal axes (X-coordinates) are identical and the vertical axis (Y-coordinate) is within a predetermined range. Moreover, 3-dimensional coordinates and the like may be used rather than using the two-dimensional coordinates.

In the case of FIG. 15, as for the outlet port 4c that is determined to be positioned under the server, the detecting unit 32 detects that the cool air flows from under the server 60 in a direction from the space under the floor to the space above the floor. Further, as for the outlet ports other than the outlet port that is determined by the position determining unit 31 to be positioned under the server, the detecting unit 32 detects the directions of the cool air flowing from the outlet ports based on the coordinates of the installed wireless sensors and the coordinates of the corresponding servers.

As for the outlet ports that are determined not to be positioned under the server, the detecting unit 32 specifies whether the wireless sensor is positioned closer to the intake port or the exhaust port of the server based on the position coordinates of the wireless sensor specified by the position determining unit 31 and the position coordinates of the server. Moreover, the detecting unit 32 calculates the coordinates of a vector that extends from the outlet port toward the intake port of the server as the vector coordinates of the cool air.

In the case of FIG. 15, the detecting unit 32 detects the direction of the cool air flowing from the outlet port 4a as the coordinates of a vector that extends from the air-conditioner 2 toward the server 20. Similarly, the detecting unit 32 detects the direction of the cool air flowing from the outlet port 4b as the coordinates of a vector that extends from the air-conditioner 2 toward the server 40. The detecting unit 32 detects the direction of the cool air flowing from the outlet port 4c as the coordinates of a vector that extends from under the floor toward the server 60. The detecting unit 32 detects the direction of the cool air flowing from the outlet port 4d as the coordinates of a vector that extends from the air-conditioner 2 toward the server 80. Moreover, the detecting unit 32 outputs the detection results to the device specifying unit 33.

The device specifying unit 33 specifies a server that takes in constant exhaust air from the other servers based on the direction of the cool air flowing from the outlet ports, detected by the detecting unit 32 and the coordinates of the respective servers. For example, the device specifying unit 33 compares the position coordinates of the respective servers specified by the sensor specifying unit 30 to identify the positional relation of the respective servers such as whether the other server is present in front or at the rear of a server. Moreover, the device specifying unit 33 specifies the identified positional relation of the respective servers, the vector of the cool air detected by the detecting unit 32 for each outlet port, and a server that takes in constant exhaust air from the other servers from the intake port and outlet port for each server. The device specifying unit 33 outputs the specified results to the classifying unit 34.

In the case of FIG. 15, the device specifying unit 33 specifies the server 40 as the server that takes in the cool air flowing from the outlet port 4b and constant exhaust air exhausted from the server 20. Similarly, the device specifying unit 33 specifies the server 20 as the server that mainly takes in the cool air flowing from the outlet port 4a since no other servers are present between the server 20 and the air-conditioner 2. Similarly, the device specifying unit 33 specifies the server 80 as the server that mainly takes in the cool air flowing from the outlet port 4d since the exhaust air from the server 60 is not exhausted in an upward direction, and the exhaust air from the server 60 is rarely taken in. Moreover, the device specifying unit 33 specifies the server 60 as the server that mainly takes in the cool air flowing from the outlet port 4c since the outlet port 4c is installed under the server 60.

For example, the classifying unit 34 classifies the server which is determined by the position determining unit 31 that the position of the outlet port is under the information processing device and the servers other than the server specified by the device specifying unit 33 as a first group and classifies the server specified by the device specifying unit 33 as a second group. In the case of FIG. 15, the classifying unit 34 classifies the servers 20 and 60 that are specified to take in the cool air flowing from the outlet port installed in correspondence to the subject server as a first group. Moreover, the classifying unit 34 classifies the servers 40 and 80 that are specified to take in the cool air flowing from the outlet port installed in correspondence to the subject server and the exhaust air from the other servers as a second group. The classifying unit 34 outputs the classification results to the determining unit 35.

The determining unit 35 determines whether the others server that takes in a larger air volume than the air volume acquired by the air volume acquiring unit 29b is capable of operating the VM in the order of the server belonging to the first group and the server belonging to the second group. For example, the determining unit 35 specifies the other server that is installed in the outlet port flowing a larger air volume than the air volume of the cool air flowing from the outlet port 4a.

Moreover, the determining unit 35 sorts servers belonging to the first group among the specified other servers according to the air volume and assigns priority levels so that a server having a larger air volume has a higher priority level. Similarly, the determining unit 35 sorts servers belonging to the second group among the specified other servers according to the air volume and assigns priority levels so that a server having a larger air volume has a higher priority level. After that, the determining unit 35 assigns the priority level of all of the other servers so that a server having the highest priority level in the second group has the highest priority level next to a server having the lowest priority level in the first group. Moreover, the determining unit 35 outputs the server information in which the priority levels are assigned to the migration control unit 29e.

[Process Flow]

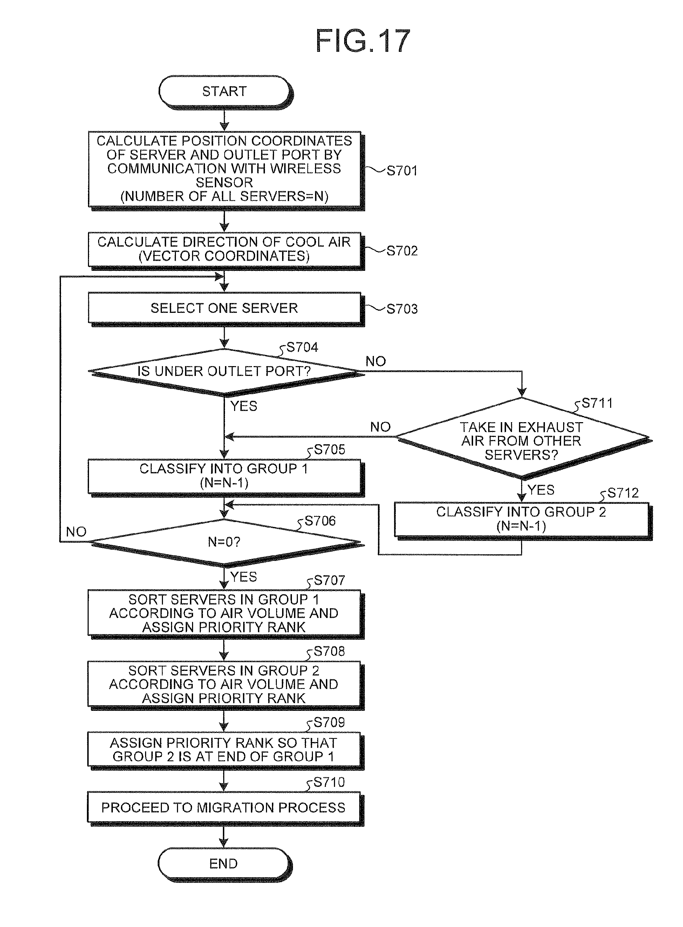

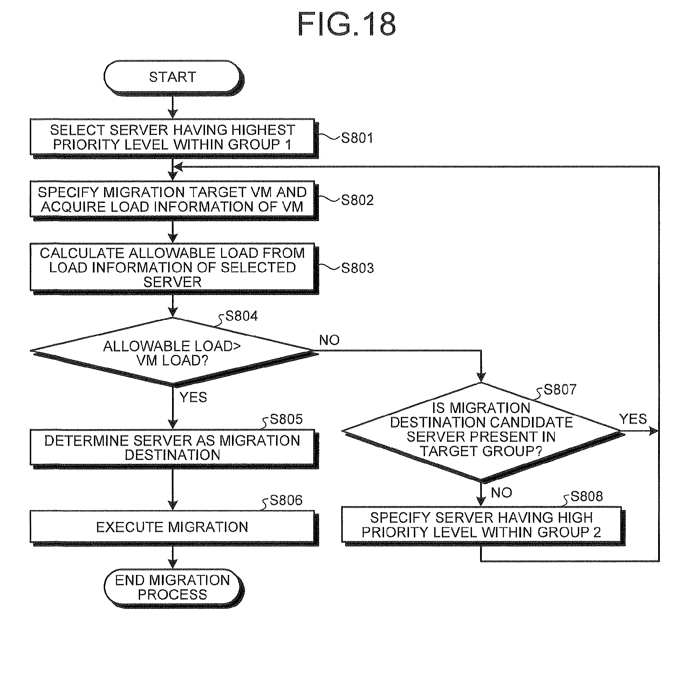

Next, the flow of the process according to the fifth embodiment will be described with reference to FIGS. 17 and 18. FIG. 17 is a flowchart illustrating the flow of a grouping process according to the fifth embodiment, and FIG. 18 is a flowchart illustrating the flow of a migration process according to the fifth embodiment.

[Flow of Grouping Process]

As illustrated in FIG. 17, the sensor specifying unit 30 specifies the position coordinates of the respective wireless sensors and the position coordinate of the corresponding servers by wireless communication with the wireless sensors installed in the respective outlet ports and uses the specified position coordinates of the wireless sensors as the position coordinates of the respective outlet ports (step S701). Here, the sensor specifying unit 30 sets the total number of servers to N (natural number).

Subsequently, the detecting unit 32 calculates the coordinates of a vector that extends from the outlet port to the intake port of the server as vector coordinates of the cool air based on the position coordinates of the wireless sensor and the position coordinates of the corresponding server (step S702). After that, the position determining unit 31 selects a certain server (step S703) and determines whether the position of each outlet port is under the server based on the coordinates of each wireless sensor specified by the sensor specifying unit 30 (step S704).

Moreover, when the position determining unit 31 determines that the position of the outlet port is under the information processing device (step S704: Yes), the classifying unit 34 classifies the server as the first group and determines whether there is another server that is to be classified as the first group (step S705). That is, when "Yes" is obtained in step S704, the classifying unit 34 sets "N" to "N-1" and determines whether "N" is "0".

On the other hand, when the position determining unit 31 determines that the position of the outlet port is not under the information processing device (step S704: No), the classifying unit 34 determines whether the server is a server that takes in constant exhaust air from the other servers (step S711). Moreover, when it is determined that the server is a server that takes in constant exhaust air from the other servers (step S711: Yes), the classifying unit 34 classifies the server as the second group (step S712) and determines whether there is another server that is to be classified as the second group (step S706). Further, when it is determined that the server is not the server that takes in constant exhaust air from the other servers (step S711: No), the classifying unit 34 classifies the server as the first group and determines whether there is another server that is to be classified as the first group (step S705).

When the classifying unit 34 has classified all servers (step S706: Yes), the determining unit 35 sorts the air volumes in the first group to assign priority levels (step S707), and sorts the air volumes in the second group to assign priority levels (step S708). After that, the determining unit 35 rearranges the groups so that the second group is located at the end of the first group and assigns priority levels to all servers (step S709), and the flow proceeds to a migration process (step S710). On the other hand, when it is determined that there is a server that is not classified by the classifying unit 34 (step S706: No), step S703 and the subsequent processes are executed on the next server.

(Flow of Migration Process)

As illustrated in FIG. 18, the determining unit 35 selects a server to which the highest priority level within the first group is assigned as a migration destination candidate (step S801). Subsequently, the determining unit 35 specifies one migration target VM from the VMs that operate in the subject server and acquires the load information of the VM from the hypervisor (step S802).

Moreover, the determining unit 35 calculates an allowable load from the load information of the migration destination candidate acquired by the information acquiring unit 29c (step S803). After that, when the allowable load is larger than the load of the migration target VM (step S804: Yes), the determining unit 35 determines the migration destination candidate as a migration destination server (step S805). Moreover, the migration control unit 29e outputs an instruction to migrate the VM to the migration destination server determined by the determining unit 35 to the hypervisor, whereby the migration of the VM is executed by the hypervisor (step S806).

On the other hand, when the allowable load is smaller than the load of the migration target VM (step S804: No), the determining unit 35 determines that the VM cannot operate in the migration destination candidate server and determines whether there is a server having the next highest priority level in the first group (step S807).

Moreover, when it is determined that there is a server having the next highest priority level in the first group (step S807: Yes), the determining unit 35 executes step S802 and the subsequent processes using the server having the next highest priority level as a new migration destination candidate. On the other hand, when it is determined that there is not the server having the next highest priority level in the first group (step S807: No), the determining unit 35 sets the second group as a processing target and selects a server to which the highest priority level in the second group is assigned as a migration destination candidate (step S808). After that, the second group is set as a processing target, and step S802 and the subsequent processes are executed. The process of FIG. 18 is executed in a number of times corresponding to the number of VMs operating in the migration source server.

[Specific Example]

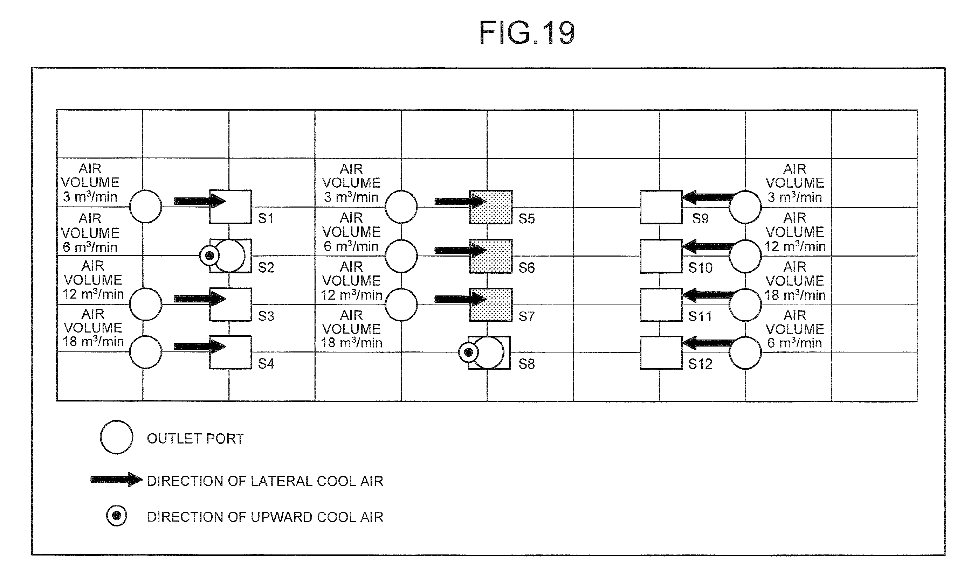

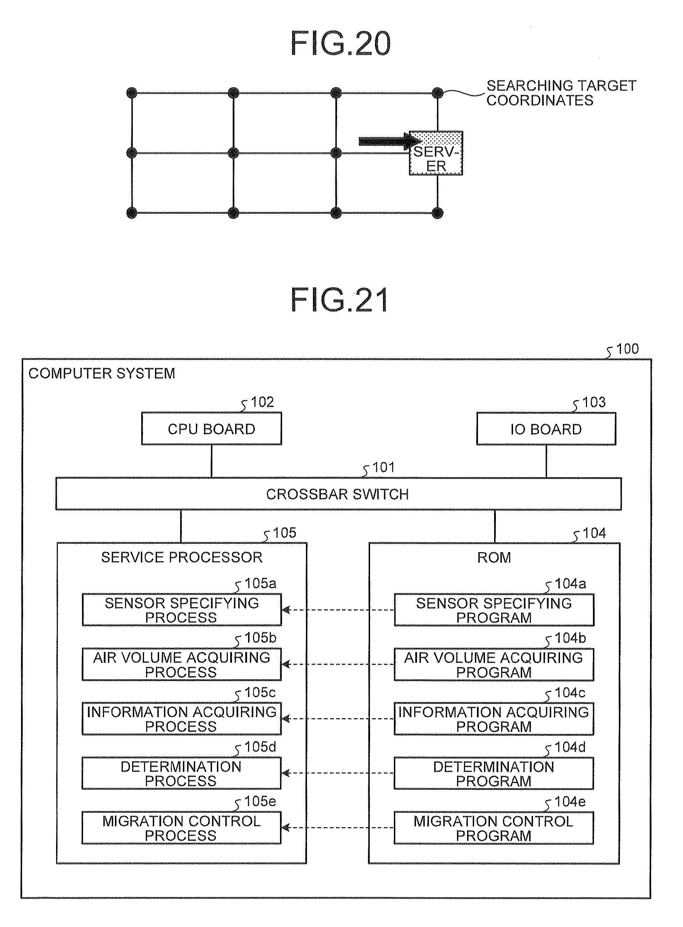

Next, a specific example of the grouping process and the priority level assigning process described in the fifth embodiment will be described with reference to FIGS. 19 and 20. FIG. 19 is a diagram illustrating a specific example of the grouping process according to the fifth embodiment, and FIG. 20 is a diagram illustrating an example of a searching range. In FIG. 19, a white circle represents an outlet port, a rectangle represents a server, a double circle represents the direction of upward cool air, and an arrow represents the direction of lateral cool air. Black circles in FIG. 20 represent searching target coordinates.

As illustrated in FIG. 19, in this example, servers S1 to S12 are installed. The server S1 takes in an air volume of 3 $m^3$/min, for example, from an outlet port installed near the subject server, and the server S2 takes in an air volume of 6 $m^3$/min, for example, from an outlet port installed under the subject server. The server S3 takes in an air volume of 12 $m^3$/min, for example, from an outlet port installed near the subject server, and the server S4 takes in an air volume of 18 $m^3$/min, for example, from an outlet port installed near the subject server.

Moreover, the server S5 takes in an air volume of 3 $m^3$/min, for example, from an outlet port installed near the subject server, and the server S6 takes in an air volume of 6 $m^3$/min, for example, from an outlet port installed near the subject server. The server S7 takes in an air volume of 12 $m^3$/min, for example, from an outlet port installed near the subject server, and the server S8 takes in an air volume of 18 $m^3$/min, for example, from an outlet port installed under the subject server.

Moreover, server S9 takes in an air volume of 3 $m^3$/min, for example, from an outlet port installed near the subject server, and the server S10 takes in an air volume of 12 $m^3$/min, for example, from an outlet port installed near the subject server. The server S11 takes in an air volume of 18 $m^3$/min, for example, from an outlet port installed near the subject server, and the server S12 takes in an air volume of 6 $m^3$/min, for example, from an outlet port installed near the subject server.

In such a condition, each server searches for other servers that are present within a predetermined range of the subject server based on the position coordinates acquired by communication with the wireless sensor. For example, the server searches for other servers that correspond to an outlet port in which the direction of the cool air is the same as the cool air from the outlet port corresponding to the subject server, within the range of the searching position coordinates illustrated in FIG. 20. The black dots illustrated in FIG. 20 are the searching target coordinates, and the server searches for the other servers from the searching target positions depicted by the black dots. The server may search the other servers within a predetermined range of the searching target positions depicted by the black dots.

Moreover, each server performs the processes of acquiring the air volume, specifying the position coordinates, and specifying the position coordinates of the server and the outlet port, and other processes to thereby classify the servers S2 and S8 under which the outlet port is positioned as the first group. Similarly, each server classifies the servers S1, S3, S4, S9, S10, S11, and S12 that are not influenced by the exhaust air from the other servers as the first group. Further, each server classifies the servers S7, S6, and S5 that are influenced by the exhaust air from the other servers as the second group.

Further, each server assigns priority levels to the first group based on the air volume taken in so that the priority rank increases in the order of the servers S4, S8, S11, S3, S10, S2, S12, S1, and S9. Further, each server assigns priority levels to the second group based on the air volume taken in so that the priority rank increases in the order of the servers S7, S6, and S5. Subsequently, each server determines the overall priority levels in the order of the servers S4, S8, S11, S3, S10, S2, S12, S1, S9, S7, S6, and S5 by putting higher priority to the first group than the second group. After that, the migration process of the migration target VM is performed based on the priority level.

[Advantageous Effect of Fifth Embodiment]

According to the fifth embodiment, each server determines whether the position of each outlet port is under the information processing device based on the coordinates of each wireless sensor. Each server detects the direction of cool air flowing from each of the outlet ports other than an outlet port that is determined to be positioned under the server, based on the coordinates of the wireless sensor installed in the outlet port and the coordinates of the corresponding server. Each server specifies a server that takes in the exhaust air from the other servers based on the detected directions of the cool air flowing from the respective outlet ports and the coordinates of the corresponding servers. Each server classifies the servers in which the position of the outlet port is determined to be under the server and the servers other than the servers that are specified to take in the exhaust air from the other servers as the first group. Each server classifies the servers that are specified to take in the exhaust air from the other servers as the second group. Each server determines whether each of the servers that take in a larger air volume than the air volume of the subject server can operate the VM in the order of the servers belonging to the first group and the servers belonging to the second group.
As a result, servers can be classified into the first group which is a group of servers that are mainly cooled by the cool air from the corresponding outlet port and the second group which is a group of servers that are cooled by taking in the exhaust air from the other servers, and the VM can be preferentially migrated to the first group having better cooling efficiency.

Sixth Embodiment

While embodiments have been described, the present invention may be embodied in various other forms other than the above embodiments. Thus, other embodiments will be described.

(Measurement of Position Coordinates)

The position coordinates of the wireless sensor can be measured and calculated by various methods other than the method of measuring the position coordinates of the wireless sensor described in the embodiments. For example, GPS may be used, and the position coordinates may be measured using an existing wireless module such as a wireless node "MOTE (registered trademark)".

(Cable Communication)

In the above embodiments, an example of acquiring the air volume from the wireless sensor connected to the air volume sensor and an example of acquiring the air volume measured by the air volume sensor from other servers have been described, but the present invention is not limited to this. For example, the air volume sensor and each server may be connected by a cable such as a LAN. In this case, each server can acquire the air volume directly from the air volume sensor not passing through the wireless sensor.

(Combination of Embodiments)

The methods described in the above embodiments may be combined in an optional manner. That is, the VM may be migrated across servers and partitions by taking the grouping of servers into consideration, and the VM may be migrated to a server that takes in a larger air volume than the subject server without taking the load information into consideration.

(Load Information)

In the above embodiments, an example of migrating the VM when it is determined that the VM can operate based on the CPU use rate of the migration destination server will be described, but the present invention is not limited to this. For example, the VM may be migrated to a server that takes in a larger air volume than the subject server without taking the load information into consideration. Moreover, optional load information such as memory usage, disk usage, or network traffic as well as the CPU use rate may be used as the load information. Further, a combination of these items of information may be used in determining whether the migration target VM can operate.
Moreover, when the CPUs of the respective servers have different performance, for example, it may be determined whether the CPU use rate allowable by the migration destination candidate server is larger than the migration target VM use rate by taking the performance difference into consideration. For example, it is assumed that the clock frequency of the CPU of a migration destination candidate server is twice that of the CPU of the migration source server. In this case, the migration source server may determine that "(allowable CPU use rate of migration destination candidate server) > (VM use rate)/2". The number of processor cores included in the CPU may be taken into consideration without being limited to the clock frequency.

(System Configuration)

Moreover, the process sequence, control sequence, specific names, and various types of information including data and parameters, described and illustrated within the document and drawings of the embodiments can be changed in an optional manner unless otherwise stated particularly. Further, in the above embodiments, although an example of operating the VM using the hypervisor, the present invention is not limited to this, and various methods, for example, a method of executing virtualization software on a host OS and operating the VM using the virtualization software, can be used.

Further, the respective constituent elements of the respective illustrated devices are functional and conceptual elements and are not necessarily configured as physical elements as illustrated in the figure. That is, a specific form of distributing and integrating respective devices is not limited to the illustrated form, and for example, the air volume acquiring unit 29b and the information acquiring unit 29c may be integrated. All or part of the respective devices may be functionally or physically distributed and integrated in optional units according to various load and usage conditions. Further, all or optional part of the processing functions performed in the respective devices may be realized by a CPU and programs analyzed and executed by the CPU and alternatively be realized as wired-logic hardware.

(Program)

Various processes described in the above embodiments can be realized when a computer system such as a server or a workstation executes preliminarily prepared programs. Thus, an example of a computer system that executes a program having the same functions as the above embodiment will be described.

FIG. 21 is a diagram illustrating an example of a computer system that executes a migration control program. As illustrated in FIG. 21, a computer system 100 includes a crossbar switch 101, a CPU board 102, an IO board 103, a ROM 104, and a service processor 105. Here, a program having the same functions as the above embodiments is stored in advance in the ROM 104. That is, As illustrated in FIG. 21, the ROM 104 stores a sensor specifying program 104a, an air volume acquiring program 104b, an information acquiring program 104c. Further, a determination program 104d and a migration control program 104e are stored in advance in the ROM 104.

As illustrated in FIG. 21, the service processor reads these programs 104a to 104e and executes the same as respective processes. That is, the programs 104a to 104e are executed as a sensor specifying process 105a, an air volume acquiring process 105b, an information acquiring process 105c, a determination process 105d, and a migration control process 105e.

The sensor information specified by the sensor specifying unit 29a illustrated in Fig. 4 is used in execution of the sensor specifying process 105a, and the air volume information acquired by the air volume acquiring unit 29b is used in execution of the air volume acquiring process 105b. Moreover, the information acquired by the information acquiring unit 29c illustrated in FIG. 4 is used in execution of the information acquiring process 105c, and the determining unit 29d is used in execution of the determination process 105d. Further, the migration control unit 29e is used in execution of the migration control process 105e.

The programs 104a to 104e may not be necessarily stored in the ROM 104. For example, the programs 104a to 104e may be stored in a "portable physical medium" such as a flexible disk (FD), a CD-ROM, a MO-disc, a DVD disc, a magneto-optical disc, or an IC card inserted in the computer system 100. Further, the programs 104a to 104e may be stored in a "fixed physical medium" such as a hard disk drive (HDD) provided inside or outside the computer system 100. Furthermore, the programs 104a to 104e may be stored in "another computer system" that is connected to the computer system 100 via a public line, the Internet, a LAN, or a WAN. Furthermore, the computer system 100 may read the programs from these media and execute the programs.

That is, the programs mentioned in other embodiments are recorded in a computer-readable manner in a recording medium such as the "portable physical medium", the "fixed physical medium", or the "communication medium" as described above. The computer system 100 realizes the same functions as the above embodiments by reading the programs from such a recording medium and executing the programs. The programs mentioned in other embodiments are not limited to being executed by the computer system 100. For example, the present invention can be equally applied when the other computer system or server executes the programs and when the computer system and the server execute the programs in collaboration.

Reference Signs List

| | |
|---|---|
| 1 | DATA CENTER |
| 1a | EXHAUST AIR |
| 1b | COOL AIR |
| 2 | AIR-CONDITIONER |
| 3 | EXHAUST PORT |
| 4a to 4d | INTAKE PORT |
| 7a to 7d | AIR VOLUME SENSOR |
| 10a to 10d | WIRELESS SENSOR |
| 11a | CONTROL I/F UNIT |
| 12a | WIRELESS I/F UNIT |
| 13a | RAM |
| 14a | ROM |
| 15a | MEMORY MANAGEMENT UNIT |
| 16a | CONTROL UNIT |
| 20, 40, 60, 80 | SERVER |
| 21 | WIRELESS I/F UNIT |
| 22 | CROSSBAR SWITCH |
| 23 TO 25 | CPU BOARD |
| 23a | MEMORY |
| 23b | NONVOLATILE RAM |
| 23c | HYPERVISOR |
| 23d | MEMORY CONTROL UNIT |
| 23e | CPU |
| 26 to 28 | IO BOARD |
| 26a | DISK |
| 26b | SAS CONTROLLER |
| 26c | NETWORK CONTROLLER |
| 26d | IO CONTROL UNIT |
| 29 | SERVICE PROCESSOR |
| 29a, 30 | SENSOR SPECIFYING UNIT |
| 29b | AIR VOLUME ACQUIRING UNIT |
| 29c | INFORMATION ACQUIRING UNIT |
| 29d, 35 | DETERMINING UNIT |
| 29e | MIGRATION CONTROL UNIT |
| 29f | INFORMATION PROVIDING UNIT |
| 31 | POSITION DETERMINING UNIT |
| 32 | DETECTING UNIT |
| 33 | DEVICE SPECIFYING UNIT |
| 34 | CLASSIFYING UNIT |

**Claims**

1. A data center comprising:

an air-conditioner; and
an information processing system including a plurality of information processing devices that is cooled with air flowing from an outlet port from the air-conditioner,
each of the plurality of information processing devices including:

an arithmetic processing unit that executes a program;
a first air volume information acquiring unit that acquires first air volume information measured by an air volume meter that measures an air volume from an outlet port corresponding to the subject device;
a second air volume information acquiring unit that acquires second air volume information measured by an air volume meter that measures an air volume from an outlet port corresponding to each of other information processing devices;

a determining unit that specifies the other information processing devices that are cooled with a larger air volume than the air volume that cools the subject device based on the first air volume information and the second air volume information; and

a migration control unit that migrates a program executed by the arithmetic processing unit to the other information processing device that is specified by the determining unit.

2. An information processing system comprising a plurality of information processing devices that is cooled with air flowing from an outlet port,

each of the plurality of information processing devices including:

an arithmetic processing unit that executes a program;

a first air volume information acquiring unit that acquires first air volume information measured by an air volume meter that measures an air volume from an outlet port corresponding to the subject device;

a second air volume information acquiring unit that acquires second air volume information measured by an air volume meter that measures an air volume from an outlet port corresponding to each of other information processing devices;

a determining unit that specifies other information processing devices that are cooled with a larger air volume than the air volume that cools the subject device based on the first air volume information and the second air volume information; and

a migration control unit that migrates a program executed by the arithmetic processing unit to the other information processing device that is specified by the determining unit.

3. The information processing system according to claim 2, wherein

each of the plurality of information processing devices further includes a load information acquiring unit that acquires load information of the other information processing device,

the determining unit further determines whether the specified other information processing device can operate the program based on the load information acquired by the load information acquiring unit in the specified other information processing device and the additional information of the subject device, and

when the determining unit determines that the specified other information processing device can operate the program, the migration control unit migrates the program to the specified other information processing device.

4. The information processing system according to claim 2, wherein

each of the plurality of information processing devices further includes a specifying unit that specifies an air volume meter corresponding to the subject device based on a distance between an air volume meter corresponding to the information processing device and the subject device, the distance being calculated by wireless communication with a wireless communication unit included in the air volume meter, and

the first air volume information acquiring unit acquires the air volume measured by the air volume meter installed in the outlet port specified by the specifying unit.

5. The information processing system according to claim 2, wherein

each of the plurality of information processing devices further includes a specifying unit that specifies an air volume meter corresponding to the subject device based on coordinates of an air volume meter corresponding to the information processing device and coordinates of the subject device, the coordinates being calculated by wireless communication with a wireless communication unit included in the air volume meter, and

the first air volume information acquiring unit acquires the air volume measured by the air volume meter installed in the outlet port specified by the specifying unit.

6. The information processing system according to claim 5, wherein

each of the plurality of information processing devices further includes:

a position determining unit that determines whether the outlet port is positioned under the information processing device based on the coordinates of the air volume meter corresponding to the information processing device specified by the specifying unit and the coordinates of a predetermined information processing device;

a detecting unit that detects the direction of the air flowing from an outlet port other than the outlet port that is determined to be positioned under the information processing device based on the coordinates of the air volume meter corresponding to the outlet port other than the outlet port that is determined by the position determining unit to be positioned under the information processing device and the coordinates of the information processing device in which the corresponding outlet port is determined not to be under the information processing device; a device specifying unit that specifies an information processing device that takes in exhaust air from the other information processing devices based on the direction of air flowing from the outlet port other than the outlet port that is determined to be positioned under the information processing device detected by the detecting unit and the coordinates of the information processing device corresponding to the outlet port other than the outlet port that is determined to be positioned under the information processing device; and

a classifying unit that classifies the information processing device in which the outlet port is determined by the position determining unit to be positioned under the information processing device and the information processing devices other than the information processing device specified by the device specifying unit into a first group, and the information processing device specified by the device specifying unit into a second group, wherein the determining unit determines whether each of the information processing devices that are cooled with a larger air volume than the air volume acquired by the first air volume information acquiring unit is an information processing device that can operate the program in the order of the information processing devices belonging to the first group and the information processing devices belonging to the second group.

7. The information processing system according to claim 3, wherein
the load information acquiring unit acquires load information of each partition of the other information processing devices,

the determining unit specifies a plurality of combinations of partitions that can operate the program based on a load allowable by each of the partitions calculated from the load information of the partitions of the other information processing devices acquired by the load information acquiring unit, and

the migration control unit migrates the program to the partitions of the other information processing device specified by the determining unit.

8. The information processing system according to claim 3, comprising a plurality of information processing devices, wherein

the determining unit specifies a combination of the plurality of other information processing devices that can operate the program based on a load allowable by each of the other information processing devices calculated from the load information of each of the plurality of other information processing devices acquired by the load information acquiring unit, and

the migration control unit migrates the program to the plurality of other information processing devices specified by the determining unit.

9. The information processing system according to any one of claims 2 to 8, wherein
the migration control unit migrates the program to the subject device when the load of the other information processing device, to which the program has migrated, reaches a predetermined value or more.

10. An information processing device comprising:

an arithmetic processing unit that executes a program;
a first air volume information acquiring unit that acquires first air volume information measured by an air volume meter that measures an air volume from an outlet port corresponding to the subject device;
a second air volume information acquiring unit that acquires second air volume information measured by an air volume meter that measures an air volume from an outlet port corresponding to each of other information processing devices;
a determining unit that specifies the other information processing devices that are cooled with a larger air volume than the air volume that cools the subject device based on the first air volume information and the second air volume information; and
a migration control unit that migrates the program executed by the arithmetic processing unit to the other information processing device that is specified by the determining unit.

11. The information processing device according to claim 10, further comprising a load information acquiring unit that acquires load information of the other information processing device, wherein
the determining unit further determines whether the specified other information processing device can operate the program based on the load information acquired by the load information acquiring unit in the specified other information processing device and the additional information of the subject device, and
when the determining unit determines that the specified other information processing device can operate the program, the migration control unit migrates the program to the specified other information processing device.

12. A method of controlling an information processing device executed by the information processing device, comprising:

acquiring first air volume information measured by an air volume meter that measures an air volume from an outlet port corresponding to the subject device;

acquiring second air volume information measured by an air volume meter that measures an air volume from an outlet port corresponding to each of other information processing devices;

specifying the other information processing devices that are cooled with a larger air volume than the air volume that cools the subject device based on the first air volume information and the second air volume information; and

migrating a program executed by an arithmetic processing unit of the subject device to the specified other information processing device.

13. The method of controlling the information processing device according to claim 12, wherein

the specifying of the information processing device includes acquiring load information of the specified other information processing device and determining whether the specified other information processing device can operate the program based on the acquired load information and the additional information of the subject device, and

the migrating includes migrating the program to the specified other information processing device when it is determined that the specified other information processing device can operate the program.

14. A control program of controlling an information processing device, the control program being executed by the information processing device, comprising:

acquiring first air volume information measured by an air volume meter that measures an air volume from an outlet port corresponding to the subject device;

acquiring second air volume information measured by an air volume meter that measures an air volume from an outlet port corresponding to each of other information processing devices;

specifying the other information processing devices that are cooled with a larger air volume than the air volume that cools the subject device based on the first air volume information and the second air volume information; and

migrating a program executed by an arithmetic processing unit of the subject device to the specified other information processing device.

15. The control program of controlling the information processing device according to claim 14, wherein

the specifying of the other information processing device includes acquiring load information of the specified other information processing device and determining whether the specified other information processing device can operate the program based on the acquired load information and the additional information of the subject device, and

the migrating includes migrating the program to the specified other information processing device when it is determined that the specified other information processing device can operate the program.

FIG.1

# FIG.2

WIRELESS SENSOR

AIR VOLUME
SENSOR
7a

10a

12a
WIRELESS
I/F UNIT

16a
CONTROL
UNIT

14a
ROM

13a
RAM

11a
CONTROL
I/F UNIT

15a
MEMORY
MANAGEMENT UNIT

# FIG.3A

| AIR VOLUME |
|------------|
| 20m³/h |

# FIG.3B

| WIRELESS SENSOR IDENTIFIER | AIR VOLUME SENSOR IDENTIFIER | COORDINATES |
|----------------------------|------------------------------|-------------|
| 01 | 001 | 101.90 |

28

# FIG.4

EP 2 631 799 A1

# FIG.5

| VM | | VM | |
|---|---|---|---|
| APPLICATION | | APPLICATION | |
| OS | | OS | ... |
| SYSTEM FIRMWARE | | SYSTEM FIRMWARE | |
| VIRTUAL CONTEXT | | VIRTUAL CONTEXT | |
| VIRTUAL MACHINE IMAGE | | VIRTUAL MACHINE IMAGE | |

HYPERVISOR — SERVICE PROCESSOR

23c                    29

# FIG.6

SERVER

CPU BOARD

NONVOLATILE MEMORY
HV

MEMORY CONTROL UNIT

CONTROL UNIT
VIRTUAL CONTEXT 0

MEMORY
VIRTUAL CONTEXT 0
VIRTUAL CONTEXT 1
...
PART OF VIRTUAL MACHINE IMAGE

IO BOARD
DISK
VIRTUAL MACHINE IMAGE

SERVER

CPU BOARD

NONVOLATILE MEMORY
HV

MEMORY CONTROL UNIT

CONTROL UNIT

MEMORY
VIRTUAL CONTEXT 1
...
PART OF VIRTUAL MACHINE IMAGE

IO BOARD
DISK

# FIG.7

START

S101
IS PROCESS START INSTRUCTION RECEIVED?

NO

YES

PERFORM COMMUNICATION WITH WIRELESS SENSORS — S102

SPECIFY NEAREST WIRELESS SENSOR — S103

ACQUIRE AIR VOLUME OF NEAREST OUTLET PORT — S104

ACQUIRE AIR VOLUMES OF OTHER OUTLET PORTS AND LOAD INFORMATION OF OTHER SERVERS — S105

PRIORITY RANK DETERMING PROCESS — S106

MIGRATION PROCESS — S107

END

## FIG.8

START PRIORITY RANK DETERMINING PROCESS

GENERATE STRUCTURE OF DATA ARRAY FOR AIR VOLUMES ($Q_X$) OF OTHER OUTLETPORTS ⟶ S201

SET TOTAL NUMBER AS "N" ⟶ S202

SET ROW NUMBER OF INITIAL COMPARISON ELEMENT AS "$i=(N-1)/2$" ⟶ S203

SET ROW NUMBER OF BASIS COMPARISON ELEMENTS AS "$a=i$" ⟶ S204

S205 — NO ← $N-1 \geqq 2*i+1$? → YES

S206 — NO ← $N-1 \geqq 2*i+2$? → YES

S209 — NO ← $Q_i < Q_{2*i+1}$? → YES

S207 — $Q_i < Q_{2*i+2}$ and $Q_{2*i+1} < Q_{2*i+2}$? — NO / YES

S211 — $i=a$

S210 — INTERCHANGE $Q_i$ WITH $Q_{2*i+1}$ AND SET $i=2*i+1$

S208 — INTERCHANGE $Q_i$ WITH $Q_{2*i+2}$ AND SET $i=2*i+2$

S212 — NO ← $i=0$? → YES

S213 — $i=i-1$

EXTRACT MAXIMUM VALUE $Q_0$ OF AIR VOLUME ⟶ S214

INTERCHANGE $Q_0$ WITH $Q_{N-1}$ ⟶ S215

$N=N-1$ ⟶ S216

S217 — NO ← $N=0$? → YES

ASSIGN PRIORITY LEVEL IN SORTED ORDER (SO THAT LARGEST AIR VOLUME HAS HIGHEST PRIORITY LEVEL) ⟶ S218

PROCEED TO MIGRATION PROCESS ⟶ S219

# FIG.9

START
MIGRATION
PROCESS

ACQUIRE SERVER HAVING HIGHEST
PRIORITY LEVEL — S301

SPECIFY MIGRATION TARGET VM AND
ACQUIRE LOAD INFORMATION OF VM — S302

CALCULATE ALLOWABLE LOAD FROM
LOAD INFORMATION OF SERVER — S303

S304
ALLOWABLE LOAD>VM LOAD? — NO

YES

DETERMINE SERVER AS MIGRATION
DESTINATION — S305

EXECUTE MIGRATION — S306

S307
IS SERVER
HAVING NEXT HIGHEST
PRIORITY LEVEL
PRESENT? — YES

NO

MAINTAIN VM — S308

END MIGRATION
PROCESS

FIG.10

# FIG.11

START

CALCULATE NUMBER OF MIGRATION TARGET VMs (NUMBER OF VMs=M) — S401

SELECT ONE VM AND ACQUIRE CPU USE RATE — S402

S403 DOES FORCIBLY RETURN MIGRATED VM? — YES

NO

ACQUIRE SERVER (MIGRATION DESTINATION CANDIDATE) HAVING HIGHEST PRIORITY LEVEL — S404

ACQUIRE PARTITION INFORMATION OF MIGRATION DESTINATION CANDIDATE SERVER ($P_{N-0}$ TO $P_{N-x}$, INITIAL VALUE x=0) — S405

ACQUIRE CPU USE RATE OF PARTITION ($P_{N-x}$) — S406

CALCULATE CPU NON-USE RATES ($\Sigma P$) FROM CPU USE RATE OF EACH PARTITION ($P_{N-0}$ TO $P_{N-x}$) — S407

CALCULATE FREE MEMORY CAPACITY — S408

S409 $\Sigma \Sigma P > CPU$ USE RATE OF MIGRATION TARGET VM AND DOES M SATISFY CAPACITY? — NO

YES

S410 ARE THERE CPU AND MEMORY OF WHICH NON-USE RATE IS 100%? — NO

YES

REBUILD PARTITION — S411

DETERMINE MIGRATION DESTINATION AND MIGRATE VM (NUMBER M OF VMs=M-1) — S412

S413 NUMBER M OF VMs=0? — NO

YES

END

S415 IS ANOTHER PARTITION PRESENT (x=MAXIMUM)? — NO

SET x=x+1 AND PROCEED TO STEP S406 — S419

YES

S416 IS SERVER HAVING NEXT HIGHEST PRIORITY LEVEL PRESENT? — YES

SELECT NEXT SERVER AND PROCEED TO STEP S405 — S418

NO

MAINTAIN VM (M=M-1) — S417

SELECT NEXT VM AND PROCEED TO STEP S402 — S414

## FIG.12

# FIG.13

START

ACQUIRE SERVER HAVING
HIGHEST PRIORITY LEVEL — S501

SPECIFY MIGRATION TARGET VM
AND ACQUIRE CPU USE RATE OF
VM — S502

CALCULATE ALLOWABLE CPU
USE RATE FROM CPU USE RATE
OF SERVER — S503

S504
ALLOWABLE
CPU USE RATE>CPU USE
RATE OF VM?

NO →

YES

S505
DETERMINE SERVER AS
MIGRATION DESTINATION

S506
EXECUTE MIGRATION

S507
TEMPORARILY STORE
ALLOWABLE LOAD OF SERVER

S508
IS SERVER
HAVING NEXT HIGHEST
PRIORITY LEVEL
PRESENT?

NO ←

YES

S509
CALCULATE ALLOWABLE CPU
USE RATE FROM CPU USE RATE
OF NEXT SERVER

S510
SUM OF
ALLOWABLE CPU USE
RATE>CPU USE RATE
OF VM?

NO →

YES

S511
RECONFIGURE PARTITION

S512
SET SHARED STORAGE AND
VIRTUAL LAN

S513
MIGRATE VM TO EACH SERVER

END

# FIG.14

```
                    ┌─────────────┐
                    │    START    │
                    └─────────────┘
                           │
                           ▼
         NO         ╱─────────────╲  ⌐S601
        ┌──────────<  IS HEAVY-LOAD >
        │           ╲ SERVER DETECTED?╱
        │            ╲───────────────╱
        │                   │ YES
        │                   ▼
        │        ┌──────────────────────┐
        │        │ COLLECT INFORMATION ON VMs│ ⌐S602
        │        │ EXECUTED IN HEAVY-LOAD SERVER│
        │        └──────────────────────┘
        │                   │
        │                   ▼
        │            ╱──────────────╲  ⌐S603
        │           ╱  IS MIGRATION   ╲      NO
        │          <  SOURCE IDENTICAL TO >──────────┐
        │           ╲  SUBJECT SERVER?  ╱             │
        │            ╲────────────────╱                │
        │                   │ YES                      │
        │                   ▼                          │
        │            ╱──────────────╲  ⌐S604           │
        │           ╱  IS ACCEPTABLE TO ╲    NO         │
        │          <   SUBJECT SERVER?   >──────┐      │
        │           ╲────────────────╱          │      │
        │                   │ YES                │      │
        │                   ▼                    ▼      │
        │        ┌──────────────────────┐  ┌──────────────────┐
        │        │ TRANSMIT INSTRUCTION TO MIGRATE VM│⌐S605  │ NOTIFY OTHER SERVERS │ ⌐S608
        │        │  TO HEAVY-LOAD SERVER │  └──────────────────┘
        │        └──────────────────────┘          │
        │                   │ ⌐S606                 │
        │                   ▼                       │
        │        ┌──────────────────────┐           │
        │        │ PERFORM (ACCEPT) VM MIGRATION│    │
        │        └──────────────────────┘           │
        │                   │                        │
        │     YES           ▼   ⌐S607                │
        └──────────< IS ANOTHER VM PRESENT? >        │
                    ╲────────────────╱               │
                           │ NO                       │
                           ▼◄───────────────────────┘
                    ┌─────────────┐
                    │     END     │
                    └─────────────┘
```

# FIG.15

EP 2 631 799 A1

FIG.16

# FIG.17

START

↓

CALCULATE POSITION COORDINATES
OF SERVER AND OUTLET PORT BY
COMMUNICATION WITH WIRELESS
SENSOR
(NUMBER OF ALL SERVERS=N) — S701

↓

CALCULATE DIRECTION OF COOL AIR
(VECTOR COORDINATES) — S702

↓

SELECT ONE SERVER — S703

↓

S704
IS UNDER OUTLET PORT? — NO →

YES ↓

S711
TAKE IN EXHAUST
AIR FROM OTHER
SERVERS?

NO ←

YES ↓

CLASSIFY INTO GROUP 2
(N=N-1) — S712

CLASSIFY INTO GROUP 1
(N=N-1) — S705

↓

S706
N=0? — NO →

YES ↓

SORT SERVERS IN GROUP 1
ACCORDING TO AIR VOLUME AND
ASSIGN PRIORITY RANK — S707

↓

SORT SERVERS IN GROUP 2
ACCORDING TO AIR VOLUME AND
ASSIGN PRIORITY RANK — S708

↓

ASSIGN PRIORITY RANK SO THAT
GROUP 2 IS AT END OF GROUP 1 — S709

↓

PROCEED TO MIGRATION PROCESS — S710

↓

END

# FIG.18

```
                    ┌──────────────┐
                    │    START     │
                    └──────┬───────┘
                           │
                           ▼
          ┌────────────────────────────────┐
          │ SELECT SERVER HAVING HIGHEST    │──S801
          │ PRIORITY LEVEL WITHIN GROUP 1   │
          └────────────────┬───────────────┘
                           │◄──────────────────────────────┐
                           ▼                                │
          ┌────────────────────────────────┐               │
          │ SPECIFY MIGRATION TARGET VM AND │──S802         │
          │ ACQUIRE LOAD INFORMATION OF VM  │               │
          └────────────────┬───────────────┘               │
                           ▼                                │
          ┌────────────────────────────────┐               │
          │ CALCULATE ALLOWABLE LOAD FROM   │──S803         │
          │ LOAD INFORMATION OF SELECTED    │               │
          │ SERVER                          │               │
          └────────────────┬───────────────┘               │
                           ▼        S804                    │
                      ◇─────────────◇      NO               │
                     < ALLOWABLE LOAD> >────────────┐       │
                      < VM LOAD?    >               │       │
                      ◇─────────────◇               ▼       │
                           │ YES                S807         │
                           ▼                  ◇──────────◇   │
          ┌────────────────────────────────┐ < IS MIGRATION > YES
          │ DETERMINE SERVER AS MIGRATION  │──S805          │  │
          │ DESTINATION                    │ < DESTINATION   >─┤
          └────────────────┬───────────────┘ < CANDIDATE     >│
                           ▼              S806 < SERVER PRESENT>
          ┌────────────────────────────────┐ < IN TARGET    > │
          │ EXECUTE MIGRATION              │  < GROUP?      >  │
          └────────────────┬───────────────┘  ◇──────────◇   │
                           ▼                       │ NO  S808 │
                    ┌──────────────┐     ┌──────────────────┐│
                    │ END MIGRATION│     │ SPECIFY SERVER    ││
                    │ PROCESS      │     │ HAVING HIGH       ├┘
                    └──────────────┘     │ PRIORITY LEVEL    │
                                         │ WITHIN GROUP 2    │
                                         └──────────────────┘
```

# FIG.19

EP 2 631 799 A1

# FIG.20

SEARCHING TARGET COORDINATES

SERV-ER

# FIG.21

COMPUTER SYSTEM — 100

CPU BOARD — 102

IO BOARD — 103

CROSSBAR SWITCH — 101

SERVICE PROCESSOR — 105

ROM — 104

SENSOR SPECIFYING PROCESS — 105a

AIR VOLUME ACQUIRING PROCESS — 105b

INFORMATION ACQUIRING PROCESS — 105c

DETERMINATION PROCESS — 105d

MIGRATION CONTROL PROCESS — 105e

SENSOR SPECIFYING PROGRAM — 104a

AIR VOLUME ACQUIRING PROGRAM — 104b

INFORMATION ACQUIRING PROGRAM — 104c

DETERMINATION PROGRAM — 104d

MIGRATION CONTROL PROGRAM — 104e

# FIG.22

EXHAUST AIR
211

210a
EXHAUST
PORT

210

AIR-CONDITIONER

211
COOL AIR
212

SERVER 201

SERVER 202

SERVER 203

211

211

211

211

211

211

212 210b

212 210c

212 210d

200

# FIG.23

EXHAUST PORT

SERVER

AIR-CONDITIONER

d

OUTLET PORT

h

| | INTERNATIONAL SEARCH REPORT | | International application No. |
|---|---|---|---|
| | | | PCT/JP2010/068764 |

A. CLASSIFICATION OF SUBJECT MATTER
*G06F9/50*(2006.01)i, *F24F11/02*(2006.01)i, *G06F9/46*(2006.01)i

According to International Patent Classification (IPC) or to both national classification and IPC

B. FIELDS SEARCHED

Minimum documentation searched (classification system followed by classification symbols)
G06F9/46-9/54, F24F11/02

Documentation searched other than minimum documentation to the extent that such documents are included in the fields searched
Jitsuyo Shinan Koho        1922-1996   Jitsuyo Shinan Toroku Koho   1996-2010
Kokai Jitsuyo Shinan Koho   1971-2010   Toroku Jitsuyo Shinan Koho    1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 2010-72733 A (NEC Corp.),<br>02 April 2010 (02.04.2010),<br>paragraphs [0018] to [0051]; fig. 1 to 4<br>(Family: none) | 1-5,7-15<br>6 |
| Y<br>A | JP 2006-208000 A (Hewlett-Packard Development<br>Co., L.P.),<br>10 August 2006 (10.08.2006),<br>paragraphs [0007] to [0017]; fig. 1<br>& US 2006/0168975 A1    & GB 2423573 A | 1-5,7-15<br>6 |
| Y<br>A | Toshikazu WATANABE, Data Center Server Room-<br>Muke Assessment Service, Data Center Kanzen<br>Guide, 21 December 2009 (21.12.2009), first<br>edition, pages 102 to 103 | 1-5,7-15<br>6 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 05 November, 2010 (05.11.10) | 16 November, 2010 (16.11.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2010/068764 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | WO 2008/062864 A1  (NEC Corp.),<br>29 May 2008 (29.05.2008),<br>paragraphs [0081] to [0089]; fig. 7<br>& US 2010/0005465 A1 | 3,7,8,11,13,<br>15 |
| Y | JP 2010-151867 A  (Brother Industries, Ltd.),<br>06 July 2010 (06.07.2010),<br>paragraphs [0021] to [0056]; fig. 3<br>(Family: none) | 4,5 |
| Y | JP 2007-58530 A  (Nohmi Bosai Ltd.),<br>08 March 2007 (08.03.2007),<br>paragraphs [0020] to [0021]; fig. 4<br>(Family: none) | 4,5 |
| Y | JP 2008-40645 A  (Hitachi, Ltd.),<br>21 February 2008 (21.02.2008),<br>paragraphs [0092] to [0094]; fig. 3<br>& US 2008/0034076 A1 | 9 |
| A | JP 2009-244999 A  (Fujitsu Ltd.),<br>22 October 2009 (22.10.2009),<br>paragraphs [0014] to [0077]; fig. 1 to 7<br>& US 2009/0249333 A1 | 1-15 |
| A | JP 2008-276320 A  (NEC Corp.),<br>13 November 2008 (13.11.2008),<br>paragraphs [0014] to [0034]; fig. 1 to 5<br>(Family: none) | 1-15 |

Form PCT/ISA/210 (continuation of second sheet) (July 2009)

**EP 2 631 799 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006208000 A

- JP 2009293851 A

### Non-patent literature cited in the description

- *Green Data Center (Latest Technology on Air-Conditioning,* 26 July 2009, http://www.impress-rd.jp/idc/2008spring/sp1/part1souron.html

- position detection using radio signals. *OKI Technical Review,* October 2005, vol. 72 (4), 204